(19)

**Europäisches Patentamt**
**European Patent Office**
**Office européen des brevets**

(11) **EP 3 191 822 B1**

(12) **EUROPÄISCHE PATENTSCHRIFT**

(45) Veröffentlichungstag und Bekanntmachung des Hinweises auf die Patenterteilung:
**20.07.2022 Patentblatt 2022/29**

(21) Anmeldenummer: **15750040.6**

(22) Anmeldetag: **11.08.2015**

(51) Internationale Patentklassifikation (IPC):
*G01N 24/08* (2006.01)     *G01R 33/38* (2006.01)
*G01S 15/02* (2006.01)     *G01N 27/00* (2006.01)
*G01S 15/86* (2020.01)     *G01S 13/88* (2006.01)
*G01S 13/02* (2006.01)     *G01S 13/86* (2006.01)
*G01S 15/88* (2006.01)

(52) Gemeinsame Patentklassifikation (CPC):
**G01N 24/08; G01R 33/3808; G01S 13/0209;**
**G01S 13/86; G01S 13/88; G01S 15/86; G01S 15/88**

(86) Internationale Anmeldenummer:
**PCT/EP2015/068414**

(87) Internationale Veröffentlichungsnummer:
**WO 2016/037783 (17.03.2016 Gazette 2016/11)**

(54) **HANDMESSGERÄT UND VERFAHREN ZU DESSEN BETRIEB**

HAND-HELD MEASURING APPARATUS AND METHOD FOR THE OPERATION THEREOF

APPAREIL DE MESURE À MAIN ET SON PROCÉDÉ D'UTILISATION

(84) Benannte Vertragsstaaten:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorität: **12.09.2014 DE 102014218364**

(43) Veröffentlichungstag der Anmeldung:
**19.07.2017 Patentblatt 2017/29**

(73) Patentinhaber: **Robert Bosch GmbH**
**70442 Stuttgart (DE)**

(72) Erfinder:
• **KRAPF, Reiner**
**70794 Filderstadt (DE)**
• **KURZ, Felix**
**71711 Steinheim (DE)**

(56) Entgegenhaltungen:
EP-A2- 2 182 390     US-A1- 2014 009 170
US-A1- 2014 084 927

• **FERRARA C ET AL: "Integrated GPR and unilateral NMR approach to estimate water content in a porous material", ADVANCED GROUND PENETRATING RADAR (IWAGPR), 2011 6TH INTERNATIONAL WORKSHOP ON, IEEE, 22. Juni 2011 (2011-06-22), Seiten 1-4, XP031907146, DOI: 10.1109/IWAGPR.2011.5963912 ISBN: 978-1-4577-0332-4**
• **PRADO ET AL: "NMR hand-held moisture sensor", MAGNETIC RESONANCE IMAGING, ELSEVIER SCIENCE, TARRYTOWN, NY, US, Bd. 19, Nr. 3-4, 1. April 2001 (2001-04-01), Seiten 505-508, XP027372168, ISSN: 0730-725X [gefunden am 2001-04-01]**
• **LUCA SENNI ET AL: "Moisture content and strain relation in wood by Bragg grating sensor and unilateral NMR", WOOD SCIENCE AND TECHNOLOGY ; JOURNAL OF THE INTERNATIONAL ACADEMY OF WOOD SCIENCE, SPRINGER, BERLIN, DE, Bd. 44, Nr. 1, 15. Juli 2009 (2009-07-15), Seiten 165-175, XP019777953, ISSN: 1432-5225**

# EP 3 191 822 B1

**Beschreibung**

Stand der Technik

Die vorliegende Erfindung betrifft ein mobiles, insbesondere handgehaltenes Messgerät zur zerstörungsfreien Bestimmung einer in einem Werkstück vorhandenen Feuchte.

Aus der DE 10 2008 055 196 A1 ist eine Vorrichtung zum Senden und/oder Empfangen elektromagnetischer Hochfrequenzsignale, insbesondere eine Ultrabreitband-Sensoreinheit für eine Radareinrichtung mit zumindest einem planaren Strahlerelement bekannt. Insbesondere kann die Vorrichtung zur Detektion und Klassifizierung von Wandfeuchte eingesetzt werden.

Die EP 2 182 390 A2 beschreibt ein Handmessgerät zur zerstörungsfreien Bestimmung eines eine Materialeigenschaft eines Werkstücks betreffenden Materialmesswerts. In dem Gehäuse des Handmessgeräts können verschiedene Sensoren vorgesehen sein. Insbesondere kann eine Sensorvorrichtung einen auf einem dielektrischen Verfahren basierenden Sensor aufweisen. Das Messgerät enthält eine Steuer- und eine Auswertevorrichtung.

Aus dem Stand der Technik sind ausserdem Handmessgeräte bekannt, welche mittels eines NMR-Sensors die Feuchtigkeit ermitteln können, z.B. Prado et al., "NMR hand-held moisture sensor", MRI, Bd. 19, Nr. 3-4, Seiten 505-508 (2001), oder Ferrara C. et al., "Integrated GPR and unilateral NMR approach to estimate water content in a porous material", 2011, 6th International Workshop on Advanced Ground Penetrating Radar, IEEE, 22-24.06.2011, Seiten 1-4.

Offenbarung der Erfindung

Das erfindungsgemäße mobile Messgerät, insbesondere Handmessgerät, geht aus von einem Messgerät zur zerstörungsfreien Bestimmung einer in einem Werkstück vorhandenen Feuchte, und weist Gehäuse auf, in dem eine erste Sensorvorrichtung, eine zweite Sensorvorrichtung, eine Steuervorrichtung zur Ansteuerung der ersten und/oder der zweiten Sensorvorrichtung, eine Auswertevorrichtung zur Auswertung zumindest eines von der ersten und/oder der zweiten Sensorvorrichtung gelieferten Messsignals, sowie eine Vorrichtung zur Energieversorgung des Messgeräts vorgesehen sind.

Erfindungsgemäß weist die erste Sensorvorrichtung zumindest einen Kernspinresonanz-Sensor (NMR-Sensor) auf, wobei der Kernspinresonanz-Sensor eine Vorrichtung zur Detektion einer Magnetfeldänderung, insbesondere eine Empfangsspule zur Detektion einer Magnetfeldänderung, eine erste Vorrichtung zur Erzeugung eines ersten Magnetfels zur Ausrichtung von Kernspins und eine zweite Vorrichtung, insbesondere eine Hochfrequenzspule, zur Erzeugung eines zweiten Magnetfelds zur Anregung der Kernspins aufweist, welches das erste Magnetfeld überlagert, wobei die Steuervorrichtung zumindest eine Steuereinheit zur Steuerung der zweiten Vorrichtung aufweist, wobei die Steuereinheit zur Modifikation des zweiten Magnetfelds, insbesondere zur Erzeugung von Pulssequenzen, vorgesehen ist, und die zweite Sensorvorrichtung zumindest einen Sensor aus einer Gruppe von Kapazitäts-, Mikrowellen-, Ultraschall-, Widerstands-, Leitfähigkeits- und Radar-Sensoren, insbesondere Ultrabreitband-Radar- und Breitband-Impuls-Radar-Sensoren, aufweist, wobei die Auswertevorrichtung dazu eingerichtet ist, durch Auswertung eines von der ersten Sensorvorrichtung gelieferten Messsignals eine Information über die im Werkstück vorhanden Feuchte zu gewinnen, wobei die Steuervorrichtung unter Verwendung der Information zur optimierten Ansteuerung der zweiten Sensorvorrichtung und/oder die Auswertevorrichtung unter Verwendung der Information zur optimierten Auswertung von von der zweiten Sensorvorrichtung gelieferten Messsignalen eingerichtet ist.

Unter Werkstück sollen insbesondere zusammenhängende Teile eines Materials verstanden werden. Beispielsweise und nicht abschließend kann es sich dabei um eine Wand, einen Boden, eine Decke, Estrich, ein organisches Gebilde (insbesondere Teile eines Körpers) und/oder Teile eines Geländes handeln. Bestehen können diese Werkstoffe beispielsweise insbesondere aus Holz, Glas, Kunststoff, Beton, Stein, Ziegel, Gips, Metall, organischen Materialien oder dergleichen. Des Weiteren lassen sich prinzipiell auch Flüssigkeiten untersuchen.

Unter "eine Materialeigenschaft eines Werkstücks betreffender Materialmesswert" soll im Folgenden insbesondere eine das Material charakterisierende Information verstanden werden, die durch Anwendung des Messgeräts ermittelt wird. Vorzugsweise handelt es sich bei der Information um eine quantitative Aussage über eine physikalische und/oder chemische Größe oder Eigenschaft, die insbesondere mittels eines Kennwerts und/oder eines Zahlenwerts beschreibbar ist. Alternativ oder zusätzlich können die Materialmesswerte auch eine logische und/oder eine vergleichende Aussage umfassen. Unter "eine Materialeigenschaft des Werkstücks betreffenden Materialmesswerten" können beispielsweise insbesondere Werte verstanden werden, die eine Dichte, eine Porosität, eine Konzentration, insbesondere eine Konzentration eines andersartigen Materials in dem Material des Werkstücks, ein Mischungsverhältnis eines oder mehrerer Materialien, eine Zusammensetzung eines Materials, etc. betreffen. Die Erfindung betrifft jedoch ausschliesslich die in dem Werkstück vorhandene Feuchte als die zu bestimmende Materialeigenschaft des Werkstücks.

Unter Handmessgerät soll insbesondere verstanden werden, dass das Messgerät ohne Zuhilfenahme einer Transportmaschine lediglich mit den Händen, insbesondere mit einer Hand, transportiert und insbesondere auch während eines Messvorgangs entlang eines Werkstücks geführt werden kann. Dazu beträgt die Masse des Handmessgeräts insbesondere weniger als 5 kg, vorteilhaft weniger als 3 kg und besonders vorteilhaft weniger als 1 kg. Vorzugsweise kann das Messgerät einen Griff oder einen Griffbereich aufweisen, mit dem das Messgerät über einen zu untersuchenden Gegenstand geführt werden kann, insbesondere über ein Werkstück geführt werden kann.

Es wird vorgeschlagen, dass die Komponenten der Sensorvorrichtungen, der Steuervorrichtung, der Auswertevorrichtung sowie der Vorrichtung zur Energieversorgung des Messgeräts zumindest teilweise in dem Gehäuse des Messgeräts untergebracht sind. Insbesondere sind die Komponenten in ihrem Gesamtvolumen zu mehr als 50 %, bevorzugt zu mehr als 75 % und besonders bevorzugt zu 100 % in dem Gehäuse des Messgeräts untergebracht. Auf diese Weise kann ein kompaktes, leicht einhändig führbares Messgerät realisiert werden. Des Weiteren lassen sich die Komponenten auf diese Weise vorteilhaft vor Beschädigungen und Umwelteinflüssen, beispielsweise Feuchtigkeit und Staub, schützen.

Das mobile Messgerät weist eine Steuervorrichtung zur Ansteuerung der ersten und/oder der zweiten Sensorvorrichtung auf. Unter der Steuervorrichtung soll insbesondere eine Vorrichtung mit zumindest einer Steuerelektronik verstanden werden, die Mittel zur Kommunikation mit den anderen Komponenten des Messgeräts, beispielsweise Mittel zur Steuerung und Regelung der ersten und/oder der zweiten Sensorvorrichtung, und/oder Mittel zur Datenverarbeitung und/oder weitere, dem Fachmann als sinnvoll erscheinende Mittel aufweist. Insbesondere ist die Steuervorrichtung dazu vorgesehen, zumindest einen Betriebsfunktionsparameter des Messgeräts in Abhängigkeit von zumindest einer Nutzereingabe und/oder einem Auswerteergebnis der Auswerteeinheit einzustellen. Unter "vorgesehen" soll insbesondere speziell "programmiert", "ausgelegt" und/oder "ausgestattet" verstanden werden. Darunter, dass ein Objekt zu einer bestimmten Funktion "vorgesehen" ist, soll insbesondere verstanden werden, dass das Objekt diese bestimmte Funktion in zumindest einem Anwendungs- und/oder Betriebszustand erfüllt und/oder ausführt oder dazu ausgelegt ist, die Funktion zu erfüllen. Vorteilhaft kann unter der Steuerelektronik der erfindungsgemäßen Steuervorrichtung eine Prozessoreinheit in Verbindung mit einer Speichereinheit sowie mit einem in der Speichereinheit gespeicherten Betriebsprogramm verstanden werden, das während des Steuervorgangs ausgeführt wird. Insbesondere können die elektronischen Bauteile der Steuervorrichtung auf einer Platine (Leiterplatte) angeordnet sein, bevorzugt in Form eines Mikrokontrollers. Besonders vorteilhaft kann die Steuervorrichtung darüber hinaus dazu vorgesehen sein, das gesamte Messgerät zu steuern und dessen Betrieb zu ermöglichen. Dazu ist die Steuervorrichtung vorgesehen, mit den anderen Komponenten des Messgeräts, insbesondere der ersten und der zweiten Sensorvorrichtung, der Auswertevorrichtung, einer Eingabe- und/oder einer Ausgabevorrichtung sowie einer Datenkommunikationsschnittstelle zu kommunizieren.

Unter der Auswertevorrichtung zur Auswertung zumindest eines von der ersten und/oder der zweiten Sensorvorrichtung gelieferten Messsignals soll zumindest eine Vorrichtung verstanden werden, die einen Informationseingang zur Annahme von Messsignalen, eine Informationsverarbeitungseinheit zur Bearbeitung, insbesondere Auswertung der angenommenen Messsignale, sowie eine Informationsausgabe zur Weitergabe der bearbeiteten und/oder ausgewerteten Messsignale aufweist. Vorteilhaft weist die Auswerteeinheit Komponenten auf, die zumindest einen Prozessor, einen Speicher und ein Betriebsprogramm mit Auswerte- und Berechnungsroutinen umfassen. Insbesondere können die elektronischen Bauteile der Auswertevorrichtung auf einer Platine (Leiterplatte) angeordnet sein, bevorzugt auf einer gemeinsamen Platine mit der Steuervorrichtung, besonders bevorzugt in Form eines Mikrokontrollers. Des Weiteren können die Steuervorrichtung und die Auswertevorrichtung besonders bevorzugt auch als ein einzelnes Bauteil ausgeführt sein. Die Auswertevorrichtung ist vorgesehen, die von der ersten und/oder der zweiten Sensorvorrichtung erhaltenen Messsignale auszuwerten und daraus zumindest eine Information betreffend eine Materialeigenschaft des Werkstücks, insbesondere betreffend eine im Werkstück vorhandene Feuchte, abzuleiten.

Des Weiteren kann die Auswerte- und/oder die Steuervorrichtung gespeicherte Korrektur- und/oder Kalibriertabellen aufweisen, die es erlauben, Auswerteergebnisse zu interpretieren und/oder umzurechnen und/oder zu inter- und/oder extrapolieren sowie das Messgerät insbesondere hinsichtlich eines Werkstückmaterials zu kalibrieren.

Die Vorrichtung zur Energieversorgung des Messgeräts ist dazu vorgesehen, das Messgerät zur Inbetriebnahme und während des Betriebs mit elektrischer Energie zu versorgen. Bevorzugt handelt es sich bei dieser Vorrichtung um einen stromnetzunabhängigen Energiespeicher, insbesondere einen Akkumulator, eine Batterie, eine Brennstoffzelle, einen Kondensator, einen anderweitigen, dem Fachmann sinnvoll erscheinenden Energiespeicher oder eine Kombination/Mehrung derer. Vorzugsweise eigenen sich zur Energieversorgung des Messgeräts insbesondere Akkumulatoren mit einer Zellchemie, die eine hohe Leistungs- und/oder Energiedichte bereitstellt. Dazu gehören derzeit beispielsweise Akkumulatoren der Lithium- und Lithium-Ionen-Zellchemie, insbesondere Lithium-Eisenphosphat-, Lithium-Manganoxid-, Lithium-Nickel-Cobalt-Mangan-Oxid-, überlithiierte Lithium-Nickel-Cobalt-Mangan-Oxid-, Lithium-Schwefel-, Lithium-Polymer- und Lithium-Sauerstoff-Akkumulatoren. Vorzugsweise weist die Vorrichtung zur Energieversorgung eine lösbare Formschluss- und/oder Kraftschlussverbindungsschnittstelle auf. Unter lösbar soll in diesem Zusammenhang insbesondere zerstörungsfrei trennbar verstanden werden. Somit ist die Vorrichtung zur Energieversorgung bevorzugt abnehmbar und austauschbar an dem Messgerät anordenbar. Besonders bevorzugt lässt sich die abnehmbare Vorrichtung zur Energieversorgung in und/oder außerhalb des Messgeräts wieder mit Energie aus einem Stromnetz versorgen und laden.

Erfindungsgemäß weist die erste Sensorvorrichtung des Messgeräts zumindest einen Kernspinresonanz-Sensor auf, der zumindest zur Gewinnung einer ersten Information über eine Materialeigenschaft des Werkstücks, insbesondere über eine im Werkstück vorhandene Feuchte, insbesondere zur Bestimmung eines Feuchtemesswerts des Werkstücks, insbesondere zur Bestimmung eines Feuchtemesswerts in dem Werkstück, vorgesehen ist. Die Funktionsweise des Kernspinresonanz-Sensors basiert auf dem kernphysikalischen Effekt, bei dem Atomkerne einer Materialprobe, insbesondere in dem Werkstück, in einem Magnetfeld elektromagnetische Wechselfelder absorbieren und emittieren. Dabei beruht die Kernspinresonanz auf der Präzession (Larmorpräzession) von Kernspins der Atomkerne in der Materialprobe um die Magnetfeldlinien eines konstanten, insbesondere statischen, ersten Magnetfelds. Insbesondere werden die Kernspins der Atomkerne in der Materialprobe durch das erste Magnetfeld ausgerichtet. Wird Energie in Form eines zweiten elektromagnetischen Feldes, insbesondere eines Wechselfeldes, beispielsweise eines gepulsten Magnetfeldes, auf die Atomkerne eingestrahlt, die mit der Larmorpräzession deren Kernspins in Resonanz ist (Energiequanten), so können die Atomkerne die Orientierung ihrer Spins relativ zum ersten Magnetfeld durch Absorption dieser Energie ändern. Das zweite eingestrahlte Magnetfeld dient daher der Anregung der Kernspins, die unter Energieaufnahme ihre Kernspinzustände ändern. Äquivalent führt die Emission von Energiequanten in Folge einer Rückkehr der angeregten Kernspins in ein anderes, niedrigeres Energieniveau, zur Emission eines elektromagnetischen Wechselfeldes, welches sich mittels einer Vorrichtung zur Detektion einer Magnetfeldänderung, insbesondere einer Antenne und/oder einer Spule, beobachten lässt.

Vorteilhaft erlaubt der Kernspinresonanz-Sensor Atomkerne der Materialprobe im Werkstück mittels elektromagnetischer Wechselfelder anzuregen sowie ein Ausgangssignal aufgrund eines Kernspinresonanzeffektes zu generieren. Bei geeigneter Wahl der Betriebsparameter des Kernspinresonanz-Sensors kann mittels der Amplitude und/oder Relaxationszeiten des Antwortsignals unmittelbar auf die Menge einer Element-Spezies, insbesondere auf die Menge an Wasserstoffatomen, in dem untersuchten Volumen geschlossen werden, aus der sich eine Information über die Materialeigenschaft des Werkstücks, insbesondere eine Information über eine im Werkstück vorhandene Feuchte, auswerten lässt. Vorteilhaft lassen sich auf diese Weise insbesondere absolute Feuchtemesswerte des Materials des Werkstücks bestimmen.

Unter Anregung von Atomkernen soll insbesondere verstanden werden, dass die Energie der eingestrahlten elektromagnetischen Felder, insbesondere Wechselfelder, eine Änderung der Kernspins der Atomkerne bewirkt. Ferner wird im Folgenden davon ausgegangen, dass insbesondere veränderliche Magnetfelder mit elektrischen Feldern gekoppelt sind (vgl. Maxwell-Gleichungen), sodass keine Unterscheidung zwischen elektrischem Feld und Magnetfeld vorgenommen wird. Zur Anregung von Kernspinresonanz-Effekten kommt es insbesondere auf die durch eine eingestrahlte elektromagnetische Strahlung übertragene Energie an. Vorteilhaft lässt sich diese Energie mittels gepulster elektromagnetischer Felder übertragen.

Unter "Materialeigenschaft eines Werkstücks" soll wie oben beschrieben insbesondere eine das Material zumindest teilweise charakterisierende Eigenschaft verstanden werden, die durch Anwendung des Messgeräts ermittelt wird. Vorzugsweise handelt es sich dabei um eine physikalische und/oder eine chemische Eigenschaft des Materials des Werkstücks und/oder in dem Werkstück eingeschlossener anderer Materialien. Im Folgenden werden im Wesentlichen Beispiele betreffend eine Untersuchung von Feuchte in dem Werkstück vorgestellt, da die Erfindung ausschliesslich die Bestimmung einer in einem Werkstück vorhandenen Feuchte betrifft.

Selbstverständlich lassen sich die relevanten Grundsätze auch auf andere Materialeigenschaften, beispielsweise insbesondere Dichten, Porositäten, Konzentrationen, insbesondere Konzentrationen eines andersartigen Materials in dem Material des Werkstücks, Mischungsverhältnisse eines oder mehrerer Materialien, Zusammensetzungen des Materials, etc. übertragen. In diesem Sinne kann der im Folgenden verwendete Begriff Feuchte auch durch jeden anderen, die Materialeigenschaft eines Werkstücks beschreibenden Begriff und insbesondere auch durch die oben genannten Begriffe wie Dichte, Porosität, Konzentration, Mischungsverhältnis, Zusammensetzung und dergleichen ersetzt werden.

Unter Bestimmung eines Feuchtemesswerts eines Werkstücks, insbesondere in einem Werkstück, mittels des Kernspinresonanz-Sensors soll insbesondere verstanden werden, aus den erhaltenen Kernspinresonanzmessdaten Aussagen abzuleiten, die unter anderem einen relativen und/oder absoluten Feuchtegehalt und/oder einen Feuchtegradienten in das Werkstück hinein und/oder Bindungszustände des die Feuchtigkeit bildenden Wassers und/oder zeitlich dynamische Prozesse des die Feuchtigkeit bildenden Wassers betreffen. Besonders vorteilhaft erlaubt das mobile Messgerät die Bestimmung von Feuchtemesswerten eines Werkstücks, insbesondere in einem Werkstück, ohne Zerstörung des Werkstücks. Insbesondere handelt es sich bei dem Messverfahren um ein nicht zerstörendes, insbesondere kontaktloses Messverfahren, d.h. ein Feuchtemesswert kann in einer Ausführungsform des erfindungsgemäßen Messgeräts auch ohne jeglichen Kontakt des Messgeräts zu der zu vermessenden Probe, gegebenenfalls auch ohne Kontakt zu dem zu untersuchenden Werkstück, erhalten werden. Ein Positionieren des Messgeräts, insbesondere des darin enthaltenen Kernspinresonanz-Sensors, in unmittelbarer Nähe zur Werkstückoberfläche ermöglicht die Bestimmung von Feuchtemesswerten bis zu einer Materialtiefe von einigen Zentimeter in das Werkstück hinein. Besonders vorteilhaft erlaubt der Kernspinresonanz-Sensor auf diese Weise, in einem zugänglichen Messbereich bis zu dieser Materialtiefe ein Feuchteprofil, insbesondere einen Gradienten der Feuchte in dem Material des Werkstücks, absolut zu bestimmen. Die realisierbare Messtiefe ist insbesondere durch physikalische Parameter des Kernspinresonanz-Sensors limitiert.

Zur Bestimmung von die Materialeigenschaft eines Werkstücks betreffenden Feuchtemesswerten, kann eine Kalibrierung des Messgeräts, insbesondere eine Kalibrierung der Sensorvorrichtung, vorgesehen werden. So kann für die Feuchtebestimmung kann beispielsweise eine Kalibriermessung an einer reinen Wasserprobe (z.B. Glas gefüllt mit Wasser), die nach Einschalten des Messgeräts durchgeführt wird, zur Festlegung einer maximalen Feuchte (entsprechend 100%) und somit zur Kalibrierung des Messgeräts durchgeführt werden. Alle dann folgenden Messungen, insbesondere Messungen an einem zu untersuchenden Werkstück, werden anschließend in Bezug zu dieser Kalibriermessung ausgewertet. Ferner können, wenn das mittels der Sensorvorrichtung untersuchte Volumen bekannt ist, eine absolute Feuchte sowie volumetrische Größen, insbesondere eine Konzentration, eine Volumen-Prozent-Information oder dergleichen, ausgewertet werden.

Darüber hinaus können vorteilhaft weitere Informationen, beispielsweise betreffend die Zusammensetzung, Schichtdicken und/oder Salzgehalt des Materials des Werkstücks, ermittelt werden.

Weiterhin weist das Messgerät erfindungsgemäß eine zweite Sensorvorrichtung auf, welche zumindest einen Sensor aus einer Gruppe von Kapazitäts-, Mikrowellen-, Ulraschall-, Widerstands-, Leitfähigkeits- und Radar-Sensoren, insbesondere Ultrabreitband-Radar- und Breitband-Impuls-Radar-Sensoren, aufweist. Vorteilhaft erlaubt diese zweite Sensorvorrichtung mittels Aussendung und/oder Empfang und/oder Vermessung von in das Werkstück eindringenden elektromagnetischen Feldern, insbesondere auch Aussendung und/oder Empfang und/oder Vermessung von in das Werkstück eindringenden Hochfrequenz-Signalen, eine zerstörungsfreie Bestimmung einer zweiten, die Materialeigenschaft des Werkstücks, insbesondere die Feuchte des Werkstücks, betreffenden Information.

Diese zweite Sensorvorrichtung erlaubt, weitere, nicht notwendigerweise redundante Informationen neben den durch die erste Sensorvorrichtung bestimmten Informationen zu ermitteln. Es Z können (nichterfindungsgemäss) komplementäre, d.h. unterschiedliche Materialeigenschaften des Werkstücks betreffende Informationen, und/oder dieselbe Materialeigenschaft des Werkstücks betreffende Informationen unter Verwendung beider Sensorvorrichtungen erhalten werden.

Erfindungsgemäß wird vorgeschlagen, dass durch Auswertung zumindest eines von der ersten Sensorvorrichtung gelieferten Messsignals eine Information über eine im Werkstück vorhandene Feuchte gewonnen wird, die zur optimierten Ansteuerung der zweiten Sensorvorrichtung und/oder optimierten Auswertung der von der zweiten Sensorvorrichtung gelieferten Messsignale vorgesehen ist. Besonders vorteilhaft kann somit ein Messergebnis, das unter Verwendung des Kernspinresonanz-Sensors erhalten wird, also insbesondere ein absoluter Feuchtemesswert und/oder ein Feuchtegradient innerhalb des Messbereichs (Messtiefe) des Kernspinresonanz-Sensors, zur optimierten Ansteuerung der zweiten Sensorvorrichtung und/oder optimierten Auswertung von von der zweiten Sensorvorrichtung gelieferten Messsignalen genutzt werden.

Unter "optimierter Ansteuerung der zweiten Sensorvorrichtung" soll insbesondere verstanden werden, dass die erste, die Materialeigenschaft eines Werkstücks betreffende Information genutzt wird, zumindest eine Kenngröße und/oder einen Steuerparameter der Steuervorrichtung zur Ansteuerung der zweiten Sensorvorrichtung zu beeinflussen, vorteilhaft zu verbessern und/oder zu optimieren, besonders vorteilhaft zu kalibrieren, mit dem Ziel, an die Gegebenheiten des Werkstücks angepasste und damit verbesserte und/oder genauere Messungen mit der zweiten Sensorvorrichtung durchzuführen. Vorteilhaft und nicht abschließend können diese Steuerparameter und Kenngrößen physikalische und/oder technische Parameter wie beispielsweise Spannungen, Stromstärken, Pulsdauern, Leistungen, Ausstrahlungsrichtungen etc. zum Betrieb der zweiten Sensorvorrichtung betreffen.

Unter "optimierter Auswertung von von der zweiten Sensorvorrichtung gelieferten Messsignalen" soll insbesondere verstanden werden, dass die erste, die Materialeigenschaft des Werkstücks betreffende Information genutzt wird, zumindest eine Auswerteroutine und/oder einen Auswertevorgang der Auswertevorrichtung zu beeinflussen, vorteilhaft zu verbessern und/oder zu optimieren, besonders vorteilhaft zu kalibrieren, mit dem Ziel, an die Gegebenheiten des Werkstücks angepasste und damit verbesserte und/oder genauere Auswertungen von von der zweiten Sensorvorrichtung gelieferten Messsignalen zu ermöglichen. Besonders vorteilhaft erlaubt die optimierte Auswertung, die Feuchte betreffende Informationen, die mit der zweiten Sensorvorrichtung ermittelt werden, insbesondere beispielsweise relative Feuchtemesswerte, in Bezug zu einer mit der ersten Sensorvorrichtung ermittelten, die Feuchte des Werkstücks betreffenden Information, insbesondere beispielsweise zu einem absoluten Feuchtemesswert und/oder einem Feuchtegradienten in das Werkstück hinein, zu setzen. Auf diese Weise kann besonders vorteilhaft eine Kalibrierung von Messsignalen der zweiten Sensorvorrichtung und/oder eine Kalibrierung der Auswertung dieser Messsignale durchgeführt werden.

Erfindungsgemäss weist die zweite Sensorvorrichtung zumindest einen Sensor aus einer Gruppe von Kapazitäts-, Mikrowellen-, Ultraschall-, Widerstands-, Leitfähigkeits- und/oder Radar-Sensoren, insbesondere Ultrabreitband-Radar- und/oder Breitband-Impuls-Radar-Sensoren, auf.

In Bezug auf die Feuchte kann eine oberflächennahe Bestimmung eines, insbesondere relativen, Feuchtemesswerts basierend auf resistiven Messverfahren, beispielsweise mittels Leitfähigkeitsmessung zwischen zwei in das Werkstück gedrückten Spitzen, erfolgen. Alternativ und/oder zusätzlich kann basierend auf kapazitiven Messverfahren beispielsweise eine Permittivität des oberflächennahen Materials des Werkstücks durch an das Werkstück angelegte Elektroden erhalten werden.

Vorteilhaft ermöglicht die Verwendung von Radar- und/oder Mikrowellen, welche mittels mindestens einer Antenne in das Werkstück eingestrahlt und deren materialinternen Reflektionen und/oder Streuung empfangen werden, eine Materialeigenschaft eines Werkstücks betreffende Materialmesswerte in einer signifikant größeren Messtiefe, insbesondere verglichen mit dem Kernspinresonanz- oder dem Leitfähigkeits-Messverfahren, zu ermitteln. Vorteilhaft ermöglicht die Verwendung von Radar- und/oder Mikrowellen daher auch, die Permittivität des Werkstücks in einer signifikant größeren Messtiefe, insbesondere verglichen mit dem Kernspinresonanz- oder dem Leitfähigkeits-Messverfahren, zu ermitteln. Dieses Messverfahren erlaubt ebenfalls eine unkalibrierte, insbesondere relative Messung eines Feuchtemesswerts des Werkstücks, insbesondere in dem Werkstück. Es lassen sich insbesondere relative Feuchtemessungen für Materialtiefen von bis zu 10 cm, vorteilhaft von bis zu 15 cm und besonders vorteilhaft von größer 15 cm realisieren.

Besonders vorteilhaft kann ein Radar-Sensor zur tiefenaufgelösten Vermessung verwendet werden.

Eine absolute Feuchtemessung bei diesen Messverfahren ist insbesondere nur dann möglich, wenn die Trockenpermittivität $\varepsilon_T$, d.h. die Permittivität des vollständig trockenen Materials des Werkstücks, bekannt ist und somit der gemessene Feuchtemesswert in Bezug zur Trockenpermittivität $\varepsilon_T$ gesetzt und ein entsprechender Masseanteil an Wasser berechnet werden kann.

Besonders vorteilhaft kann ein Messergebnis, das unter Verwendung des Kernspinresonanz-Sensors erhalten wird, also insbesondere ein absoluter Feuchtemesswert und/oder ein Feuchtegradient innerhalb des Messbereichs (Messtiefe) des Kernspinresonanz-Sensors, zur optimierten Ansteuerung der zweiten Sensorvorrichtung und/oder optimierten Auswertung von von der zweiten Sensorvorrichtung gelieferten Messsignale genutzt werden.

Ein mit dem Kernspinresonanz-Sensor ermittelter Feuchtemesswert, insbesondere ein absoluter Feuchtemesswert und/oder ein Feuchtegradient in das Werkstück hinein, kann zur Bestimmung der Trockenpermittivität $\varepsilon_T$ des Materials des Werkstücks beitragen und somit als Berechnungsgrundlage für die zweite Sensorvorrichtung, beispielsweise einen Radarsensor, genutzt werden. Insbesondere kann vorgesehen sein, die Trockenpermittivität $\varepsilon_T$ aus Messsignalen des Kernspinresonanz-Sensors alleine zu bestimmen oder unter Zuhilfenahme von Messsignalen des zweiten Sensors. Auf diese Weise können besonders vorteilhaft absolute Feuchtemesswerte bis zu einer signifikant größeren Materialtiefe in das Werkstück hinein ermittelt werden und der Messbereich des Messgeräts erheblich erweitert werden. Es lassen sich auf diese Weise insbesondere absolute Feuchtemessungen für Materialtiefen von bis zu 10 cm, vorteilhaft von bis zu 15 cm und besonders vorteilhaft von größer 15 cm realisieren.

Der Kernspinresonanz-Sensor des mobilen Messgeräts enthält eine erste Vorrichtung zur Erzeugung eines ersten Magnetfelds, insbesondere eines ersten Magnetfelds mit definiertem Feldgradienten, eine zweite Vorrichtung, insbesondere eine Hochfrequenzspule und/oder eine Antenne, zur Erzeugung eines zweiten Magnetfelds auf, welches das erste Magnetfeld überlagert, wobei die Steuervorrichtung zumindest eine Steuereinheit zur Steuerung der zweiten Vorrichtung aufweist, wobei die Steuereinheit insbesondere zur Modifikation des zweiten Magnetfelds, insbesondere zur Erzeugung von Pulssequenzen, vorgesehen ist.

Das durch die erste Vorrichtung erzeugte erste Magnetfeld dient der Ausrichtung der Kernspins der in dem Material des Werkstücks vorhandenen Atomkerne in dem Sinne, dass sich die Kernspins auf Grund ihres magnetischen Kernspinmoments an den Magnetfeldlinien des Magnetfelds ausrichten, insbesondere um die Magnetfeldlinien des Magnetfelds präzidieren. Eine Anregung der Kernspins erfolgt in Folge einer Einstrahlung von Energie in Form eines mittels der zweiten Vorrichtung erzeugten elektromagnetischen Feldes, insbesondere eines elektromagnetischen Wechselfeldes, beispielsweise eines gepulsten Magnetfeldes.

Unter der ersten Vorrichtung zur Erzeugung eines ersten Magnetfelds, insbesondere mit definiertem Feldgradienten, können insbesondere Vorrichtungen wie Permanentmagnete, Elektromagnete, Spulenvorrichtungen verstanden werden. Das von der ersten Vorrichtung erzeugte Magnetfeld wird typischerweise mit $B_0$ bezeichnet.

Unter der zweiten Vorrichtung zur Erzeugung eines zweiten Magnetfelds können prinzipiell die gleichen Mittel verstanden werden, vorteilhaft wird diese zweite Vorrichtung jedoch mittels einer Hochfrequenzspule und/oder einer Antenne realisiert. Besonders vorteilhaft wird die Hochfrequenzspule mit einer Frequenz im Mega-Hertz-Bereich betrieben. Insbesondere liegt die Frequenz unter 900 Mega-Hertz, bevorzugt unter 200 Mega-Hertz und besonders bevorzugt unter 50 Mega-Hertz.

Die Steuereinheit zur Steuerung der zweiten Vorrichtung, d.h. zur Steuerung vorzugsweise der Hochfrequenzspule, ermöglicht es, Pulssequenzen des zweiten Magnetfelds zu erzeugen, sodass das durch die zweite Vorrichtung erzeugte zweite Magnetfeld zeitlich und ortsabhängig modifiziert werden kann. Mittels der Pulssequenzen können besonders vorteilhaft die Kernspins der Atomkerne des Materials, das in dem untersuchten Werkstück vorhanden ist, durch elektromagnetische Wechselfelder zur Absorption und Emission von Energiequanten, insbesondere zu Resonanz angeregt werden.

Erfindungsgemäss weist der Kernspinresonanz-Sensor eine Vorrichtung zur Detektion einer Magnetfeldänderung, insbesondere eine Empfangsspule zur Detektion einer Magnetfeldänderung, auf, die es ermöglicht, mittels durch Kernspinrelaxation verursachte Magnetfeldänderungen auf materialspezifische Kenngrößen zu schließen.

Vorteilhaft kann mit der Vorrichtung zur Detektion einer Magnetfeldänderung ein Kernspinresonanzeffekt der in dem Werkstück vorhandenen und angeregten Kernspins der Atomkerne in Folge einer Beeinflussung des ersten und/oder des zweiten Magnetfelds detektiert werden. Ein Umklappen der Kernspins der Atomkerne, bei dem ein elektromagnetisches Feld emittiert wird, kann besonders vorteilhaft mittels einer Empfangsspule in Form einer durch die Magnetfeldvariation induzierten Spannung und/oder einen induzierten Strom detektiert werden. Diese Spannung und/oder dieser Strom kann zur Auswertung des Kernspinsignals an die Auswertevorrichtung weitergeleitet werden.

In einer alternativen Ausführungsform des erfindungsgemäßen Messgeräts kann die Empfangsspule auch durch die Hochfrequenzspule der zweiten Vorrichtung zur Erzeugung des zweiten Magnetfelds realisiert sein. In diesem Fall macht sich die Resonanz der Kernspins der Atomkerne dadurch bemerkbar, dass ein Umklappen der Kernspins, gefolgt von einer Aussendung eines elektromagnetischen Felds, in der Spule eine Spannung (äquivalent: einen Strom) induziert, die sich mit der angelegten Wechselspannung überlagert, sodass Einflüsse auf die zur Betreibung der Hochfrequenzspule nötige Leistung detektiert werden können.

In einer vorteilhaften Ausführungsform des erfindungsgemäßen Messgeräts ist das durch die erste Vorrichtung des Kernspinresonanz-Sensors erzeugte erste Magnetfeld im Wesentlichen parallel zu einer ersten Gehäuseseite des Messgeräts und das durch die zweite Vorrichtung erzeugte Magnetfeld im Wesentlichen senkrecht zu dem ersten Magnetfeld ausgerichtet.

Die erste Gehäuseseite ist eine im Wesentlichen ebene Außenwand des Gehäuses, die das Messgerät zu seiner Umgebung hin begrenzt. Insbesondere ist die erste Gehäuseseite bei Anwendung des Messgeräts dem zu untersuchenden Werkstück zugewandt und insbesondere von einem Bediener abgewandt.

Die Orientierung des ersten Magnetfelds kann durch zumindest zwei Permanentmagnetpole (Nord, Süd) eines Permanentmagneten erzeugt werden, insbesondere wenn sich die Pole in einer Nord-Süd-Ausrichtung parallel zur und in der Nähe der ersten Gehäuseseite befinden. Diese Anordnung lässt sich insbesondere konstruktiv einfach durch Verwendung eines Hufeisenmagnets realisieren.

Das zur Ausrichtung der Kernspins der in der Materialprobe vorhandenen Atomkerne verwendete erste Magnetfeld weist insbesondere eine Magnetfeldstärke von mehr als 0.1 Tesla auf, bevorzugt von mehr als 1.5 Tesla und besonders bevorzugt von mehr als 5 Tesla. Insbesondere eignen sich starke Permanentmagnete zur Erzeugung dieses Magnetfeldes, beispielsweise hergestellt aus Ferriten oder bevorzugt als Eisen-Cobalt-Nickel-Legierung oder besonders bevorzugt als Neodym-Eisen-Bor- oder Samarium-Cobalt-Legierung.

Alternativ kann die Magnetfeldausrichtung des ersten Magnetfelds durch zumindest zwei Permanentmagnete realisiert werden, die senkrecht zur Oberfläche der ersten Gehäuseseite des Messgeräts antiparallel, insbesondere innerhalb des Gehäuses, und in der Nähe der ersten Gehäuseseite ausgerichtet sind. Die vom Nordpol des ersten Permanentmagneten zum Südpol des zweiten Permanentmagneten verlaufenden Magnetfeldlinien können als im Wesentlichen parallel zur ersten Gehäuseoberfläche des Messgeräts angesehen werden, wenn die beiden Permanentmagnete mit einem Abstand zueinander ausgerichtet sind. Insbesondere soll unter "im Wesentlichen parallel" verstanden werden, dass ein erster Bereich existiert, in dem die das erste Magnetfeld beschreibenden Magnetfeldlinien als nahezu parallel angesehen werden können. Insbesondere beträgt in diesem ersten Bereich die Abweichung der Magnetfeldlinien von einer theoretischen Parallele weniger als 20 Grad, vorteilhaft weniger als 10 Grad und besonders vorteilhaft weniger als 5 Grad.

Das zweite Magnetfeld, das zum ersten Magnetfeld im Wesentlichen senkrecht verläuft, kann in einer besonders vorteilhaften Ausführungsform mit einer Spule und/oder einer Antenne, insbesondere mit einer Hochfrequenzspule, erzeugt werden. Die Spule ist dazu insbesondere in einer Ebene parallel und in unmittelbarer Nähe zur Oberfläche der ersten Gehäuseseite, vorzugsweise im Inneren des Gehäuses, alternativ auch außen auf dem Gehäuse oder in der Gehäusewand, angeordnet. Die Magnetfeldlinien des durch die stromdurchflossene Spule erzeugten Magnetfelds verlaufen in Nähe der Spule senkrecht zur Spulenebene. Unter "im Wesentlichen senkrecht zu dem ersten Magnetfeld" soll hier verstanden werden, dass ein zweiter Bereich existiert, in dem die das zweite Magnetfeld beschreibenden Magnetfeldlinien als nahezu senkrecht zu den Magnetfeldlinien des ersten Magnetfelds angesehen werden können. Insbesondere beträgt die Winkel-Abweichung der Magnetfeldlinien des ersten und des zweiten Magnetfelds von der Senkrechten weniger als 20 Grad, vorteilhaft weniger als 10 Grad und besonders vorteilhaft weniger als 5 Grad. Besonders vorteilhaft fallen der erste und der zweite Bereich zusammen.

Die Magnetfeldausrichtung des ersten Magnetfelds kann ebenfalls erreicht werden durch zwei parallel zur ersten Gehäuseseite und kollinear angeordnete Permanentmagnete, d.h. in Nord-Süd/Nord-Süd-Abfolge, wobei sich zwischen diesen beiden Permanentmagneten eine Hochfrequenzspule befindet, deren Wicklungsebene kollinear zur Erstreckungsrichtung der Permanentmagnete und parallel zur ersten Gehäuseseite liegt. Die beschriebene Anordnung ist dabei ebenfalls in Nähe zur ersten Gehäuseseite positioniert.

Durch geeignete Positionierung der Vorrichtungen zur Erzeugung der Magnetfelder in Nähe zur ersten Gehäuseseite wird vorteilhaft erreicht, dass sich der Bereich, in dem sich die beiden Magnetfelder überlagern, zumindest teilweise außerhalb des Gehäuses des Messgeräts befindet, sodass ein Eingriff der Magnetfelder in das zu untersuchende Werkstück ermöglicht wird.

In einer alternativen Ausführungsform ist das durch die erste Vorrichtung des Kernspinresonanz-Sensors erzeugte erste Magnetfeld im wesentlichen senkrecht zu der ersten Gehäuseseite des Messgeräts und das durch die zweite Vorrichtung erzeugte zweite Magnetfeld im wesentlichen senkrecht zu dem ersten Magnetfeld ausgerichtet.

In einer vorteilhaften Ausführungsform des mobilen Messgeräts ist die zweite Vorrichtung des Kernspinresonanz-Sensors zur Erzeugung des zweiten Magnetfelds, insbesondere die Hochfrequenzspule, austauschbar realisiert.

Unter "austauschbar" soll insbesondere verstanden werden, dass die Hochfrequenzspule eine lösbare Formschluss- und/oder Kraftschlussverbindungsschnittstelle aufweist, mittels der die Spule zerstörungsfrei vom Messgerät trennbar, insbesondere von einem Endanwender austauschbar ist. Somit ist die Spule bevorzugt abnehmbar und austauschbar an dem Messgerät anordenbar. Zur Realisierung der Austauschbarkeit kann das Messgerät insbesondere auf der ersten Gehäuseseite einen Zugang zur zweiten Vorrichtung des Kernspinresonanz-Sensors aufweisen.

Auf diese Weise kann realisiert werden, dass Spulen mit unterschiedlichen Charakteristiken, insbesondere Windungszahlen, Geometrie sowie Drahtstärken, zerstörungsfrei getauscht und anschließend verwendet werden können. Vorteilhaft können durch geeignete Wahl der Spule die durch die zweite Vorrichtung erzeugten Magnetfelder variiert und den erforderlichen Betriebsbedingungen, insbesondere dem Material des zu untersuchenden Werkstücks, angepasst werden. Des Weiteren kann erreicht werden, dass der Bereich, in dem sich das erste und das zweite Magnetfeld überlagern, in seiner Lage verschoben und/oder in seiner Geometrie modifiziert wird.

In einer vorteilhaften Ausführungsform des mobilen Messgeräts definieren die Magnetfelder des Kernspinresonanz-Sensors einen ersten sensitiven Bereich des Kernspinresonanz-Sensors, insbesondere einen schichtförmigen Bereich, der sich im Wesentlichen parallel und beabstandet zu der ersten Gehäuseseite außerhalb des Gehäuses des Messgeräts erstreckt.

Dieser erste sensitive Bereich liegt insbesondere im Überlagerungsfeld des ersten und des zweiten Magnetfelds. In Abhängigkeit der Frequenz (Larmorfrequenz) des eingestrahlten elektromagnetischen Felds und der statischen Magnetfeldstärke des ersten Magnetfelds wird der erste sensitive Bereich im Idealfall durch eine Fläche definiert, auf der die Magnetfeldstärke des ersten Magnetfelds konstant ist und insbesondere einen definierten Betrag aufweist. In Realität ist diese Fläche auf Grund nicht exakter, d.h. nicht diskreter, Frequenzen tatsächlich schichtförmig. Da ferner die Magnetfeldlinien nicht exakt parallel verlaufen, kann der erste sensitive Bereich folglich entlang der Magnetfeldlinien gekrümmt und/oder inhomogen, insbesondere inhomogen bezüglich seiner Schichtausdehnung, sein.

Auf diese Weise kann besonders vorteilhaft erreicht werden, dass mittels Positionierung des mobilen Messgeräts an einer Werkstückoberfläche, wobei die erste Gehäuseseite des Messgeräts in unmittelbarer Nähe zur Oberfläche des zu untersuchenden Werkstücks positioniert wird, die Magnetfelder in das Werkstück eindringen und der erste sensitive Bereich des Kernspinresonanz-Sensors in dem Werkstück zu liegen kommt.

In einer alternativen und/oder zusätzlichen Ausführungsform des Messgeräts kann die Sensorvorrichtung derart betrieben werden, dass sich der sensitive Bereich im Überlagerungsfeld der beiden Magnetfelder innerhalb des Gehäuses, insbesondere im Innern des Kernspinresonanz-Sensors, bevorzugt mittig zwischen den beiden das erste Magnetfeld aufspannenden Permanentmagnetpolen, befindet. Auf diese Weise kann konstruktiv einfach ein Messgerät realisiert werden, in das Materialproben zur Vermessung eingebracht werden können. Beispielsweise können auf diese Weise Materialproben mittels eines Probenröhrchens derart durch eine Öffnung in der ersten Gehäuseseite des Messgeräts in das Messgerät eingebracht werden, dass sie mittig zwischen den beiden das erste Magnetfeld aufspannenden Permanentmagnetpolen und somit im sensitiven Bereich des Kernspinresonanz-Sensors zu liegen kommen. Besonders vorteilhaft kann vorgesehen sein, dass zwischen den unterschiedlichen Anordnungen des sensitiven Bereichs, insbesondere zwischen einer Positionierung des sensitiven Bereichs innerhalb und außerhalb des Gehäuses des Messgeräts, umgeschaltet werden kann. Eine solche Umschaltung kann vorteilhaft mechanisch (beispielsweise durch Schirmung und/oder Umpositionierung der ersten und/oder der zweiten Vorrichtung zur Erzeugung des ersten bzw. zweiten Magnetfelds im Messgerät) oder elektronisch (beispielsweise durch Veränderung der Frequenz in der Hochfrequenzspule) realisiert werden.

Wenn das durch den ersten sensitiven Bereich definierte Volumen, d.h. das Volumen des Materials des Werkstücks, das in einer Messung untersucht wird, bekannt ist, können Absolutwerte sowie insbesondere auch volumetrische Größen des die Materialeigenschaft betreffenden Materialmesswerts, insbesondere des Feuchtemesswerts, beispielsweise eine Konzentration, eine Volumen-Prozent-Information oder dergleichen, ausgewertet werden. Das durch den ersten sensitiven Bereich definierte Volumen kann vorteilhaft konstruktionsbedingt und/oder durch eine apparative Messung bekannt sein.

Es wird ferner vorgeschlagen, dass sich der erste sensitive Bereich des Kernspinresonanz-Sensors entlang einer Senkrechten zu der ersten Gehäuseseite des Messgeräts außerhalb des Gehäuses verschieben lässt, insbesondere mechanisch und/oder elektronisch verschieben lässt, vorteilhaft um 1 cm, besonders vorteilhaft um 2 cm, insbesondere um 3 cm verschieben lässt.

Die Verschiebung des ersten sensitiven Bereichs kann dabei vorteilhaft durch Modifikation der Magnetfelder, beispielsweise durch Änderung deren Geometrie und/oder Homogenität mittels einer Spule (sog. Shim-Spule) oder einer (verfahrbaren) magnetischen Schirmung, besonders vorteilhaft auch durch Änderung der Frequenz der Hochfrequenzspule, sowie durch mechanisches Verfahren des Kernspinresonanz-Sensors im Gehäuse des Messgeräts erreicht werden. Folglich kann der erste sensitive Bereich bei konstanter Positionierung des Messgeräts innerhalb des Werkstücks derart verschoben werden, dass auf einfache und besonders wirtschaftliche Weise eine tiefenaufgelöste Messung, beispielsweise eine Messung eines Tiefenprofils und/oder eines Gradienten des Feuchtemesswerts in das Werkstück hinein, realisiert werden kann.

In einer vorteilhaften Ausführungsform des erfindungsgemäßen Messgeräts weist die zweite Sensorvorrichtung einen zweiten sensitiven Bereich auf, der sich im Wesentlichen symmetrisch bezüglich der Senkrechten zu der ersten Gehäuseseite des Messgeräts entlang dieser Senkrechten erstreckt.

Unter "zweiter sensitiver Bereich" soll insbesondere eine Erstreckungsrichtung, ein Raumwinkel oder ein Raumvolumen verstanden werden, in der die zweite Sensorvorrichtung eine maximale Empfindlichkeit aufweist. Im Falle eines Radar-Sensors stellt diese Erstreckungsrichtung beispielsweise die Hauptausstrahlungsrichtung (Raumwinkel) der elektromagnetischen Strahlung dar. Bei einer Sensorvorrichtung, die vorgesehen ist, eine maximale Empfindlichkeit in unterschiedlichen Betriebszuständen unter unterschiedlichen Raumwinkeln aufzuweisen, soll unter "zweiter sensitiver Bereich" vorteilhaft der jeweilige Raumwinkel oder ein mittlerer Raumwinkel verstanden werden. Vorteilhaft kann somit erreicht werden, dass die erste und die zweite Sensorvorrichtung des Messgeräts eine insbesondere identische Hauptmessrichtung aufweisen, die im Wesentlichen parallel zu der Senkrechten zu der ersten Gehäuseseite liegt. Unter der "Hauptmessrichtung" soll dann insbesondere eine Gerade verstanden werden, entlang der sich der erste sensitive Bereich der ersten Sensorvorrichtung verfahren lässt und entlang der sich der zweite sensitive Bereich der zweiten Sensorvorrichtung im Wesentlichen erstreckt. Somit kann erfindungsgemäß erreicht werden, dass die Bedingungen des Materials im Werkstück, die den Messungen der Materialeigenschaft, insbesondere der Feuchte, mittels erster und zweiter Sensorvorrichtung zu Grunde liegen, für die Messung mit der ersten sowie mit der zweiten Sensorvorrichtung ähnlich sind, insbesondere identisch sind. Die durch die sensitiven Bereiche definierten Volumina des Werkstücks überschneiden sich.

In einer alternativen Ausführungsform des erfindungsgemäßen Messgeräts weist die zweite Sensorvorrichtung einen alternativen zweiten sensitiven Bereich auf, der sich im Wesentlichen entlang einer zur Senkrechten zu der ersten Gehäuseseite des Messgeräts parallelen Gerade erstreckt.

Bei dieser Ausführungsform überschneiden sich die durch die sensitiven Bereiche der ersten und der zweiten Sensorvorrichtung definierten Volumina des Werkstücks nicht notwendigerweise.

In einer vorteilhaften Ausführungsform des erfindungsgemäßen Messgeräts sind Mittel vorgesehen, die erlauben, die Erstreckungsrichtung und/oder die Homogenität und/oder die Geometrie des ersten und/oder des zweiten sensitiven Bereichs zu beeinflussen.

Insbesondere können unter diesen Mitteln beispielsweise elektromagnetische Felder erzeugende Elektroden und/oder Spulen (sog. Shim-Spulen) verstanden werden, mit deren Hilfe Korrektur- und/oder Überlagerungsfelder erzeugt werden, die erlauben, die Erstreckungsrichtung und/oder die Homogenität und/oder die Geometrie des ersten und/oder zweiten sensitiven Bereichs in gewünschtem, vorteilhaften Maße zu beeinflussen, insbesondere zu homogenisieren.

Unter Homogenisierung eines sensitiven Bereichs soll insbesondere verstanden werden, dass die das elektromagnetisch Feld beschreibenden Feldlinien sowie dessen lokale elektrische Feldstärke bzw. Magnetfeldstärke nur geringen, idealerweise keinen Variationen unterliegt und insbesondere keine Feldverzerrungen aufweist.

Ferner lassen sich mit diesen Mitteln geometrische Verformungen der sensitiven Bereiche, beispielsweise eine Verkleinerung oder Vergrößerung entsprechend einer Fokussierung oder Desfokussierung des sensitiven Bereichs, erreichen.

Ferner wird vorgeschlagen, dass Schirmungsmittel vorgesehen sind, die es erlauben, Störeinflüsse der Sensorvorrichtungen untereinander zu minimieren.

Diese elektromagnetische Schirmung, die insbesondere aus ferromagnetischen Materialien und/oder Mu-Metall und/oder elektrisch leitenden Elementen bestehen kann, erlaubt die Beeinflussung des Verlaufs der Feldlinien der elektromagnetischen Felder der ersten und/oder der zweiten Sensorvorrichtung und kann vorteilhaft genutzt werden, eine effektive Schirmung der Sensorvorrichtungen untereinander zu realisieren. Besonders vorteilhaft kann eine magnetische Schirmung dazu verwendet werden, die von dem Kernspinresonanz-Sensor verwendeten Magnetfelder zumindest teilweise gegen andere Störeinflüsse, wie insbesondere elektromagnetische Strahlung der zweiten Sensorvorrichtung, abzuschirmen. Dies gilt auch umgekehrt. Ferner lassen sich vorteilhaft Komponenten des mobilen Messgeräts zumindest teilweise gegenüber elektromagnetischer Strahlung der messgerätinternen Sensorvorrichtungen abschirmen.

Unter Mu-Metall (auch: μ-Metall) ist eine weichmagnetische Legierung hoher magnetischer Permeabilität zu verstehen, die zur Abschirmung von Magnetfeldern verwendbar ist.

Des Weiteren können derartige Schirmungsmittel ebenfalls zu den Mitteln gezählt werden, die erlauben, die Erstreckungsrichtung und/oder die Homogenität und/oder die Geometrie des ersten und/oder des zweiten sensitiven Bereichs zu beeinflussen.

Es wird vorgeschlagen, dass in einer vorteilhaften Ausführungsform des mobilen Messgeräts die Auswertevorrichtung zur Auswertung von von der ersten und/oder der zweiten Sensorvorrichtung gelieferten Messsignalen ausgebildet ist, insbesondere einen relativen und/oder absoluten Feuchtegehalt und/oder einen Feuchtegradienten in das Werkstück hinein und/oder Bindungszustände des die Feuchtigkeit bildenden Wassers und/oder zeitlich-dynamische Prozesse des die Feuchtigkeit bildenden Wassers auszuwerten. Besonders vorteilhaft ist die Auswertevorrichtung zur Auswertung von von der ersten Sensorvorrichtung gelieferten Messsignalen ausgebildet, mittels Bestimmung der Anzahl von 1H-Atomen in dem Werkstück zumindest einen relativen und/oder absoluten Feuchtgehalt und/oder einen Feuchtegradienten in das Werkstück hinein und/oder Bindungszustände des die Feuchtigkeit bildenden Wassers und/oder zeitlich dynamische Prozesse des die Feuchtigkeit bildenden Wassers des Materials des Werkstücks auszuwerten.

Erfindungsgemäß kann somit das mobile Messgerät eingesetzt werden, ein Werkstück hinsichtlich Feuchtigkeit in einem der Messtiefe entsprechenden oberflächennahen Bereich umfassend mittels des Kernspinresonanz-Sensors zu charakterisieren. Aussagen über den relativen und/oder absoluten Feuchtegehalt sowie über einen Feuchtegradienten in das Werkstück hinein ermöglichen eine zuverlässige Bewertung des Werkstücks insbesondere hinsichtlich Prozessierbarkeit, Trockenheit, Schimmelgefahr, Festigkeit, Belastbarkeit und dergleichen. Insbesondere kann eine über die Feuchte des Werkstücks erhaltene Information zur Bestimmung der Trockenpermittivität $\varepsilon_T$ des Materials des Werkstücks verwendet werden. Diese Information der Trockenpermittivität $\varepsilon_T$ kann erfindungsgemäß zur optimierten Ansteuerung der zweiten Sensorvorrichtung und/oder optimierten Auswertung von von der zweiten Sensorvorrichtung gelieferten Messsignale genutzt werden.

Aussagen zu den Bindungszuständen des die Feuchtigkeit bildenden Wassers erlauben darüber hinaus festzustellen, ob es sich bei der Feuchtigkeit um freies Wasser, Kapillarwasser, physi- oder chemisorbiertes Wasser, Kristallwasser usw. handelt. Weitere Rückschlüsse auf ein mögliches Trocknungsverhalten und/oder Trocknungsergebnis lassen sich daraus ableiten.

Mit der Aufnahme und Auswertung zeitlich-dynamischer Prozesse des die Feuchtigkeit bildenden Wassers können Prozesse wie Migration, Konvektion sowie Wanderung von Wasser, insbesondere von Wasserfronten in dem Werkstoff untersucht werden. Rückschlüsse auf ein mögliches Trocknungs- bzw. Durchnässungsverhalten und/oder auf ein Trocknungsergebnis lassen sich daraus ableiten.

Weitere bautechnisch relevante Parameter, die mit der Auswertevorrichtung des mobilen Messgeräts unter Verwendung von von dem Kernspinresonanz-Sensor gelieferten Messsignalen ausgewertet werden können, umfassen insbesondere Salzgehalt, Zusammensetzung und/oder Mischverhältnis des Materials des Werkstücks sowie dessen Dichte und/oder Porosität, aber auch weitere, dem Fachmann als sinnvoll erscheinende Parameter.

Ferner ist die Auswertevorrichtung besonders vorteilhaft zur Auswertung von von der zweiten Sensorvorrichtung gelieferten Messsignalen ausgebildet, insbesondere einen relativen Feuchtemesswert des Materials des Werkstücks auszuwerten, insbesondere tiefenaufgelöst auszuwerten.

Erfindungsgemäß wird dadurch ermöglicht, unter Verwendung tief in das Werkstück eindringender elektromagnetischer Felder, beispielsweise bei Verwendung von Radar- und/oder Mikrowellen, die Permittivität des Werkstücks in einer signifikant größeren Messtiefe, insbesondere verglichen mit dem Kernspinresonanz-Messverfahren, zu ermitteln.

Besonders vorteilhaft kann ein Messergebnis, das unter Verwendung des Kernspinresonanz-Sensors erhalten wird, also insbesondere ein absoluter Feuchtemesswert und/oder ein Feuchtegradient innerhalb des Messbereichs des Kernspinresonanz-Sensors, zur optimierten Ansteuerung der zweiten Sensorvorrichtung und/oder optimierten Auswertung von von der zweiten Sensorvorrichtung gelieferten Messsignale genutzt werden.

Des Weiteren wird vorgeschlagen, dass die Steuervorrichtung des Messgeräts einen Bedienmodus aufweist, in welchem Angaben zu einem Werkstück durch Benutzereingaben spezifiziert und/oder dem Messgerät zur Verfügung gestellt werden können.

Unter Bedienmodus soll insbesondere eine Informationsverarbeitung, eine Informationsausgabe oder eine Informationseingabe bezeichnet werden, in deren Zusammenhang die Steuervorrichtung ein Betriebsprogramm, eine Regelroutine, Steuerroutine, Auswerteroutine und/oder eine Berechnungsroutine anwendet.

Angaben zu einem Werkstück können beispielsweise das Material des Werkstücks betreffen, dessen physikalischen oder chemischen Eigenschaften sowie beliebige andere, einem Fachmann als sinnvoll erscheinende Spezifikationen.

Für eine vorteilhafte Ausführungsform wird vorgeschlagen, dass die Steuervorrichtung des Messgeräts einen Bedienmodus aufweist, in welchem Ausgabeparameter der Ausgabevorrichtung spezifiziert und/oder dem Messgerät zur Verfügung gestellt werden können.

Unter Ausgabeparameter sollen alle die Ausgabe betreffenden Spezifikationen verstanden werden, insbesondere den Nutzer interessierende Kenngrößen, Ausgabeformen (z.B. als Zahl, Grafik, Karte, umgerechnete äquivalente Größen), Umrechnungsmöglichkeiten, Fehleranzeigen, Korrekturfaktoren, etc.

In einer vorteilhaften Ausführungsform des erfindungsgemäßen Messgeräts ist eine Eingabevorrichtung zur Eingabe von Arbeitsparametern vorhanden, insbesondere eine Eingabevorrichtung, die in einer zweiten Gehäuseseite des Messgeräts angeordnet ist.

Unter einer Eingabevorrichtung soll insbesondere ein Mittel verstanden werden, das dazu vorgesehen ist, zumindest eine Information von einem Bediener des Messgeräts, beispielsweise in Form einer Benutzerschnittstelle, und/oder einem anderen Gerät über eine akustische, optische, gestengestützte und/oder taktile Eingabe anzunehmen und an die Steuervorrichtung des Messgeräts weiterzuleiten. Beispielsweise kann die Eingabevorrichtung aus einem Betätigungselement, einer Tastatur, einem Display, insbesondere einem Touch-Display, einem Spracheingabemodul, einer Gestenerkennungseinheit und/oder einem Zeigegerät (beispielsweise Maus) bestehen. Ferner kann die Eingabevorrichtung zusätzlich auch außerhalb des Messgeräts vorhanden sein, beispielsweise in Form eines externen Datengeräts wie einem Smartphone, einem Tablet-PC, einem PC, oder in Form eines anderen, einem Fachmann als sinnvoll erscheinenden externen Datengeräts, das über eine Datenkommunikationsschnittstelle mit der Steuervorrichtung des Messgeräts verbunden ist. Letzteres ist besonderes dann vorteilhaft, wenn das externe Datengerät eine erweiterte Funktionalität des Messgeräts erlaubt und/oder unterstützt, beispielsweise die Erstellung einer mehrdimensionalen Karte oder eines Bodenplans mit Feuchtemesswerten.

Arbeitsparameter bezeichnen alle notwendigen und/oder sinnvollen Betriebsparameter des Messgeräts, insbesondere zu dessen Steuerung, sowie Parameter betreffend die Auswertung der Messergebnisse.

Gehäuseseite meint insbesondere eine das Messgerät zu seiner Umgebung hin begrenzende Außenwand des Gehäuses. Unter "in einer Gehäuseseite angeordnet" soll verstanden werden, dass die Eingabevorrichtung und/oder die Ausgabevorrichtung auf der zweiten Gehäuseseite in deren Oberfläche eingesetzt, aufgebracht oder anderweitig befestigt sind/ist. Insbesondere kann das Gehäuse auch selbst Bestandteil der Eingabe- bzw. Ausgabevorrichtung sein.

Vorteilhafterweise ist die zweite Gehäuseseite bei der Anwendung des Messgeräts dem Bediener zugewandt.

In einer vorteilhaften Ausführungsform des mobilen Messgeräts ist eine Ausgabevorrichtung zur Ausgabe von Arbeitsparametern und/oder Auswerteergebnissen vorhanden, insbesondere eine Ausgabevorrichtung, die in einer zweiten Gehäuseseite des Messgeräts angeordnet ist.

Unter Ausgabevorrichtung soll zumindest ein Mittel verstanden werden, das dazu vorgesehen ist, zumindest eine wechselnde Information akustisch, optisch und/oder taktil an einen Bediener auszugeben. Dies kann beispielsweise mittels eines Displays, eines Touch-Displays, eines Tonsignals, einer Veränderung eines Betriebsparameters, eines Vibrationsgebers und/oder einer LED-Anzeige realisiert werden. Insbesondere können auszugebende Informationen, beispielsweise Auswerteergebnisse und/oder Informationen betreffend einen Betriebszustand des Messgeräts, auch an eine Maschinensteuerung, insbesondere auch die Steuervorrichtung der Sensorvorrichtung, und/oder, insbesondere zur Erhöhung des Nutzerkomforts, an ein Daten verarbeitendes System ausgegeben werden. Letzteres umfasst zumindest eine Ausgabe einer Information an ein externes Gerät wie ein Smartphone, ein Tablet-PC, ein PC sowie an ein anderes, einem Fachmann als sinnvoll erscheinendes externes Datengerät, das über eine Datenkommunikationsschnittstelle mit der Auswertevorrichtung des Messgeräts verbunden ist.

Somit können also sowohl die Eingabevorrichtung als auch die Ausgabevorrichtung vorteilhaft direkt im Gehäuse des mobilen Messgeräts untergebracht sein und/oder ausgelagert werden und beispielsweise über externe Vorrichtungen realisiert werden. Letztere Realisierungsmöglichkeit umfasst explizit die Steuerung, Auswertung und Ausgabe der Messergebnisse über drahtgebundene und/oder drahtlose externe Systeme wie beispielsweise Fernbedienungen, Computersteuerungen, Tablet-PCs und/oder andere mobile Geräte wie Mobiltelefone, Smartphones etc.

In einer besonders vorteilhaften Ausführungsform des erfindungsgemäßen mobilen Messgeräts liegt die die Eingabevorrichtung und/oder die Ausgabevorrichtung aufnehmende zweite Gehäuseseite der ersten Gehäuseseite des Messgeräts gegenüber und ist insbesondere geräterückseitig angeordnet.

Auf diese Weise kann vorteilhaft erreicht werden, dass das Messgerät bei Positionierung mit den sensitiven Bereichen zu einem Werkstück hin, insbesondere mit der ersten Gehäuseseite angrenzend an das Werkstück, über die an der zweiten Gehäuseseite des Messgeräts aufgenommenen Eingabe- und/oder Ausgabevorrichtungen bedient werden kann bzw. Messergebnisse abgelesen werden können.

In einer weiteren vorteilhaften Ausführungsform des erfindungsgemäßen mobilen Messgeräts ist eine Positionsbestimmungsvorrichtung zur Erfassung zumindest einer momentanen Position und/oder Ausrichtung des Messgeräts, insbesondere bezogen auf das Werkstück, vorgesehen.

Die Positionsbestimmungsvorrichtung kann dazu insbesondere einen oder mehrere Sensoren aus einer Gruppe von Sensoren aufweisen, die zumindest neigungs-, winkel-, abstands-, translations-, beschleunigungs- sowie drehratensensitive Sensoren umfasst. Des Weiteren kann eine Positionsbestimmung auch mit anderen, einem Fachmann als sinnvoll erscheinenden Mitteln realisiert werden.

Beispielsweise lässt sich die Positionsbestimmungsvorrichtung unter Verwendung von Wälzkörpern, insbesondere unter Verwendung von am Gehäuse des Messgeräts angeordneten Rädern, die beim Verfahren des Messgeräts bezogen auf das Werkstück die Positionsänderung aufnehmen, realisieren. Da der Abstand zwischen Messgerät und Werkstück zur Erhöhung der Eindringtiefe der Magnetfelder in das Werkstück hinein vorzugsweise minimiert werden sollte, kann die Positionsbestimmungsvorrichtung besonders bevorzugt auch als optischer Wegaufnehmer, der in der bei Anwendung des Messgeräts dem zu untersuchenden Werkstück zugewandten Gehäuseseite angeordnet ist, vorgesehen sein.

Es wird weiterhin vorgeschlagen, dass die Auswertevorrichtung zur Auswertung von von der ersten und/oder der zweiten Sensorvorrichtung gelieferten Messsignalen dazu ausgebildet ist, Messsignale der ersten und/oder der zweiten Sensorvorrichtung in Abhängigkeit der Position und/oder Ausrichtung des Messgeräts, insbesondere bezogen auf das Werkstück, auszuwerten.

Somit kann vorteilhaft erreicht werden, dass ausgewertete Parameter mit einer Position des Messgeräts auf dem Werkstück korreliert werden können. Ferner lassen sich durch sukzessives Vermessen eines Werkstücks mehrdimensionale Matrizen oder Karten, in denen Messergebnisse zu Positionen und/oder Ausrichtungen des Messgeräts, insbesondere bezogen auf das Werkstück, erfasst sind, erstellen und/oder auswerten. Besonders vorteilhaft kann dies zur Generierung einer Darstellung der ausgewerteten Messsignale in Form einer Karte des Werkstücks, insbesondere auch mehrdimensionalen Karte, genutzt werden.

In einer weiteren vorteilhaften Ausführungsform des mobilen Messgeräts ist zumindest eine Speichervorrichtung zum Speichern von Messergebnissen und/oder Arbeitsparametern vorgesehen.

Diese Speichervorrichtung kann alle Formen an externen und internen elektronischen, insbesondere digitalen Speichern, umfassen, insbesondere auch Speicherchips wie USB-Sticks, Memory-Sticks, Speicherkarten, etc.

Darüber hinaus wird vorgeschlagen, dass die Steuervorrichtung und/oder die Auswertevorrichtung des erfindungsgemäßen Messgeräts eine Datenkommunikationsschnittstelle zur insbesondere drahtlosen Kommunikation aufweist, mittels der das Messgerät Messergebnisse und/oder Arbeitsparameter senden und/oder empfangen kann.

Bevorzugt verwendet die Datenkommunikationsschnittstelle ein standardisiertes Kommunikationsprotokoll zu einer Übertragung von elektronischen, insbesondere digitalen Daten. Vorteilhaft umfasst die Datenkommunikationsschnittstelle eine drahtlose Schnittstelle, insbesondere beispielsweise eine WLAN-, Bluetooth-, Infrarot-, NFC-, RFID-Schnittstelle oder eine andere, einem Fachmann als sinnvoll erscheinende drahtlose Schnittstelle. Alternativ kann die Datenkommunikationsschnittstelle auch einen kabelgebunden Adapter aufweisen, beispielsweise einen USB- oder Mikro-USB-Adapter.

Vorteilhaft können mittels der Datenkommunikationsschnittstelle Messergebnisse und/oder Arbeitsparameter von dem Messgerät an ein externes Datengerät, beispielsweise an ein Smartphone, einen Tablet-PC, einen PC, einen Drucker oder weitere einem Fachmann als sinnvoll erscheinende externe Geräte gesendet werden oder von diesen empfangen werden. Mittels der erfindungsgemäßen Ausgestaltung kann vorteilhaft eine Übertragung von Daten ermöglicht werden, die zu einer weiteren Auswertung von mit dem Messgerät erfassten Messsignalen nutzbar ist. Ferner können vorteilhaft vielfältige Zusatzfunktionen ermöglicht und eingebunden werden, die insbesondere auch eine direkte Kommunikation mit Smartphones (insbesondere über programmierte Apps) oder ähnlichen portablen Datengeräten erfordern. Diese können beispielsweise automatische Kartierungs-Funktionen, Firmware-Updates, Datennachbearbeitung, Datenaufbereitung, Datenabgleich mit anderen Geräten, oder dergleichen umfassen.

In einer weiteren Ausführungsform des erfindungsgemäßen Messgeräts weist die Sensorvorrichtung mindestens einen weiteren Sensor aus einer Gruppe von Sensoren auf, die zumindest induktions-, kapazitäts-, ultraschall-, temperatur-, feuchte-, strahlungs-, neigungs-, winkel-, magnetfeld-, beschleunigungs- sowie drehratensensitive Sensoren umfasst.

Auf diese Weise kann eine weitere Integration von ähnlichen und/oder komplementären Messinstrumenten in dem erfindungsgemäßen Messgerät realisiert werden. Beispielsweise lässt sich der Kernspinresonanz-Sensor besonders vorteilhaft mit induktions- und/oder kapazitätssensitiven Sensoren erweitern. Vorzugsweise werden die Signale der weiteren Sensoren ebenfalls durch die Auswertevorrichtung zur Auswertung der von der Sensorvorrichtung gelieferten Messsignale ausgewertet. Die Auswerteergebnisse der verschiedenen Sensoren können vorteilhaft miteinander korreliert werden, insbesondere können mittels der weiteren Sensoren erhaltene Messwerte zur Korrektur und/oder Optimierung und/oder Kalibrierung der von dem Kernspinresonanz-Sensor und/oder der von der zweiten Sensorvorrichtung ermittelten Messergebnisse verwendet werden. Alternativ kann auch eine Ausgabe der weiteren Messergebnisse als ergänzender Messwert und/oder Komplementärwert mittels der Ausgabevorrichtung stattfinden. Beispielsweise kann mittels zusätzlich integrierter Luftfeuchte- und Lufttemperatur-Sensoren eine Trocknungszeit des Werkstücks unter gegebenen Umgebungsbedingungen (Temperatur und Luftfeuchte) vorausgesagt werden.

Es wird ein erfindungsgemäßes Verfahren zur zerstörungsfreien Bestimmung einer in einem Werkstück vorhandenen Feuchte mittels eines erfindungsgemässen mobilen Messgeräts vorgeschlagen, bei welchem mittels zumindest der ersten Sensorvorrichtung mindestens eine erste Information über die im Werkstück vorhandene Feuchte gewonnen wird, und die zweite Sensorvorrichtung zur Gewinnung zumindest einer zweiten Information über die im Werkstück vorhandene Feuchte genutzt wird, wobei die erste Information zur optimierten Ansteuerung der zweiten Sensorvorrichtung und/oder zur optimierten Auswertung von von der zweiten Sensorvorrichtung gelieferten Messsignalen genutzt wird.

In einer vorteilhaften Ausgestaltung des erfindungsgemäßen Verfahrens wird die von der ersten Sensorvorrichtung gewonnene erste Information zur Kalibrierung der zweiten Sensorvorrichtung und/oder zur Kalibrierung der von der zweiten Sensorvorrichtung gelieferten Messsignale genutzt.

In einer vorteilhaften Ausgestaltung des erfindungsgemäßen Verfahrens wird zumindest die mittels der ersten Sensorvorrichtung über die im Werkstück vorhandene Feuchte gewonnene Information genutzt, die Trockenpermittivität $\varepsilon_T$ des Werkstücks zu bestimmen.

In einer vorteilhaften Ausgestaltung des erfindungsgemäßen Verfahrens wird mit der ersten und der zweiten Sensorvorrichtung parallel und/oder quasi-parallel und/oder seriell gemessen.

Insbesondere erlaubt das Verfahren die Bestimmung eines Feuchtemesswerts, wobei das Verfahren durch folgende wesentliche Schritte gekennzeichnet ist:

- Erzeugen eines ersten Magnetfelds in dem Werkstück mittels der ersten Vorrichtung
- Erzeugen von Hochfrequenz-Pulsen in dem Werkstück mittels der zweiten Vorrichtung des Messgeräts, insbesondere mittels der Hochfrequenzspule
- Detektion zumindest einer Amplitude und/oder einer Relaxationszeit eines Messsignals resultierend aus der Anregung von Kernspins in dem Werkstück, insbesondere mittels eines in einer Empfangsspule induzierten elektrischen Stroms und/oder einer induzierten elektrischen Spannung
- Extraktion von Larmor-Frequenzen aus einem Messsignal, insbesondere aus einem in einer Empfangsspule induzierten elektrischen Strom und/oder aus einer in einer Empfangsspule induzierten elektrischen Spannung
- Bestimmung feiner die Feuchte eines Werkstücks betreffende Information, aus den Messsignalen des Kernspinresonanz-Sensors, insbesondere Bestimmung eines absoluten Feuchtemesswerts und/oder eines Gradientenprofils eines Feuchtemesswerts in das Werkstück hinein
- Ermittlung der Trockenpermittivität des Werkstücks unter Verwendung der Information
- Erzeugen eines insbesondere in das Werkstück eindringenden elektromagnetischen Signals mittels der zweiten Sensorvorrichtung, insbesondere eines Radar- und/oder eines Mikrowellensignals
- Detektion von reflektierten elektromagnetischen Signalen
- Auswertung eines insbesondere relativen Feuchtemesswerts, insbesondere tiefenaufgelöst in das Werkstück hinein
- Optimierung der Ansteuerung der zweiten Sensorvorrichtung und/oder Optimierung der Auswertung von von der zweiten Sensorvorrichtung gelieferten Messsignalen mittels einer die Feuchte des Werkstücks betreffenden Information, die mit der ersten Sensorvorrichtung erhalten wird.

Zeichnungen

Die Erfindung ist anhand von in den Zeichnungen dargestellten Ausführungsbeispielen in der nachfolgenden Beschreibung näher erläutert. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen. Gleiche oder ähnliche Bezugszeichen in den Figuren bezeichnen gleiche oder ähnliche Elemente.

Es zeigen:

Figur 1     perspektivische Darstellung einer Ausgestaltung des erfindungsgemäßen mobilen Messgeräts,

Figur 2     Ansicht der zweiten Gehäuseseite derselben Ausgestaltung des erfindungsgemäßen Messgeräts,

Figur 3     schematische Seitenansicht derselben Ausgestaltung des erfindungsgemäßen Messgeräts,

Figur 4     schematische und vereinfachte Darstellung einer Ausführungsform der die erste und die zweite Sensorvorrichtung bildenden Komponenten sowie der damit erzeugten elektromagnetischen Felder,

Figur 5     schematische Darstellung eines Messverfahrens des erfindungsgemäßen Messgeräts.

Beschreibung der Ausführungsbeispiele

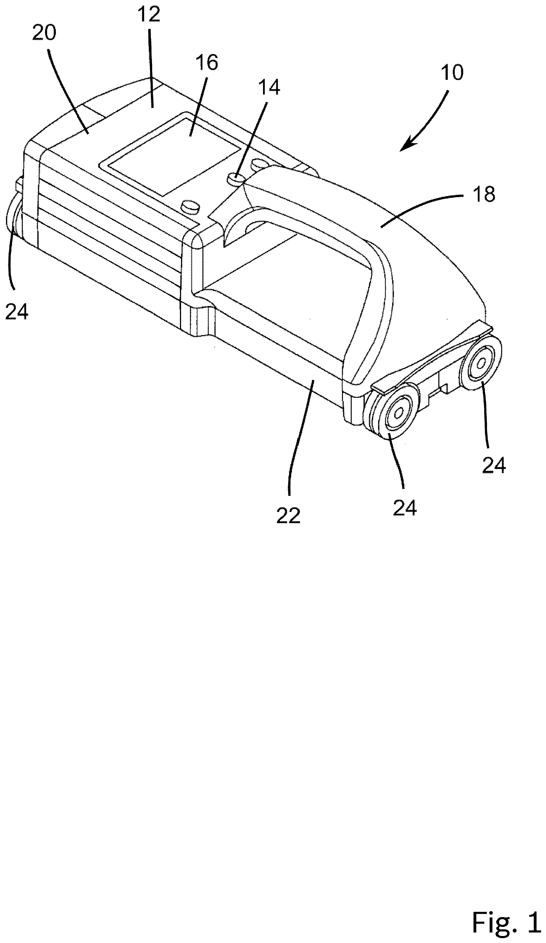

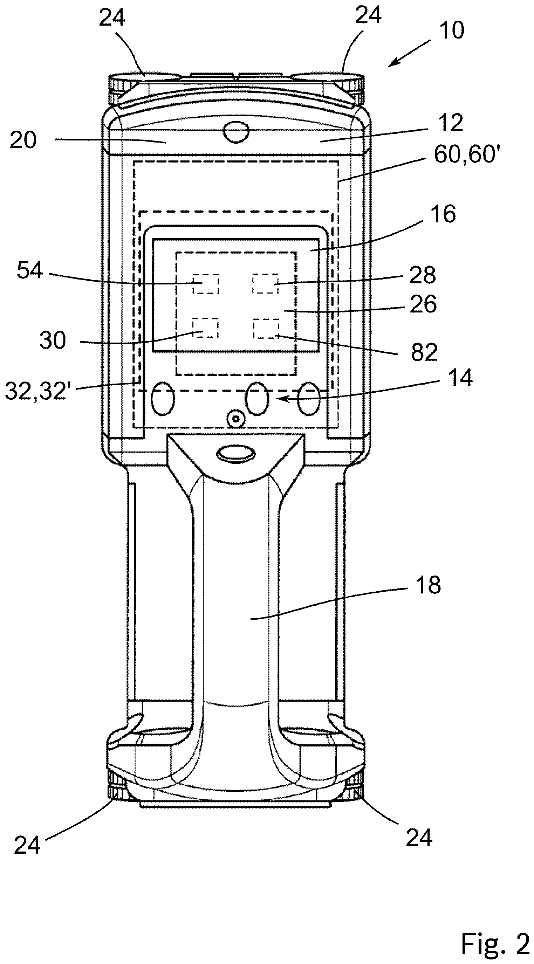

Figur 1 und Figur 2 zeigen zwei Ansichten einer beispielhaften Ausführungsform des erfindungsgemäßen Handmessgeräts 10 in perspektivischer Darstellung bzw. in vereinfachter, schematischer Aufsicht.

Das beispielhaft ausgeführte Handmessgerät 10 weist ein Gehäuse 12, eine Eingabevorrichtung in Form von Betätigungselementen 14, geeignet zum Ein- und Ausschalten des Handmessgeräts, zum Starten und Konfigurieren eines Messvorgangs und zum Eingeben von Arbeitsparametern, sowie eine Ausgabevorrichtung zur Ausgabe von Arbeitsparametern und/oder Auswerteergebnissen in Form eines Displays 16 auf. Das Handmessgerät 10 verfügt zum Transport und zu dessen Führung über einen Handgriff 18. Der Handgriff 18, die Betätigungselemente 14 sowie das Display 16 befinden sich auf einer zweiten Gehäuseseite 20 des Messgeräts 10, die bei einer Bedienung des Messgeräts typischerweise dem Anwender zugewandt ist.

Zur Energieversorgung des Handmessgeräts 10 weist das Gerät auf der, der zweiten Gehäuseseite 20 geräterückseitig gegenüberliegenden, ersten Gehäuseseite 40 (im Folgenden auch Rückseite des Messgeräts genannt) eine Aussparung auf, die vorzugsweise zur Aufnahme von stromnetzunabhängigen Energiespeichern 22, insbesondere Batterien oder wiederaufladbaren Akkus, vorgesehen ist. Das beispielhaft vorgestellte Gerät besitzt Lithium-Ionen-Akkus, deren hohe Energie- und Leistungsdichte vorteilhaft zur Energieversorgung des Messgeräts geeignet ist. In einer alternativen Ausführungsform kann der Energiespeicher 22 auch im Handgriff 18 des Messgeräts 10 untergebracht sein. Vorzugsweise weist die Vorrichtung zur Energieversorgung eine lösbare Formschluss- und/oder Kraftschlussverbindungsschnittstelle auf, sodass der Energiespeicher 22 (im Allgemeinen auch mehrere) abnehmbar und austauschbar anordenbar ist. Darüber hinaus lässt sich der Energiespeicher 22 in und/oder außerhalb des Messgeräts mit Energie aus einem Stromnetz versorgen und laden.

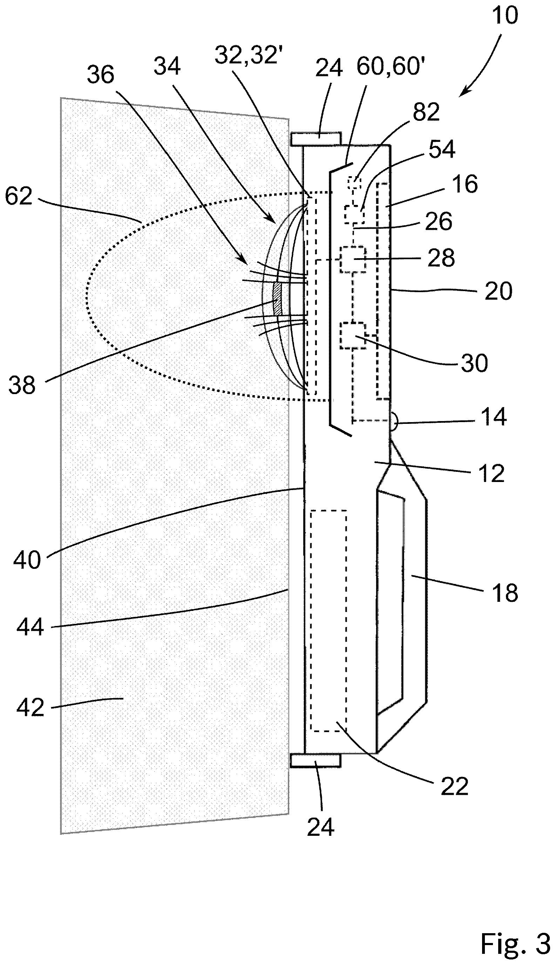

Eine Positionsbestimmungsvorrichtung des Handmessgeräts umfasst in dem Ausführungsbeispiel vier Räder 24, mittels der das Handmessgerät 10 entlang der Oberfläche 44 eines Werkstücks 42 verfahren werden kann (vgl. Fig. 3). Sensoren, die auf eine Drehung der Räder 24 sensitiv sind, erfassen eine Bewegung des Messgeräts 10 sowie eine zurückgelegte Distanz und erlauben somit Messergebnisse in Bezug zu einer Position des Messgeräts, insbesondere bezogen auf das Werkstück 42, zu setzen. In einer alternativen Ausführungsform des Messgeräts 10 kann die Positionsbestimmungsvorrichtung statt der Räder einen optischen Wegaufnehmer aufweisen. Zur präziseren Positionsbestimmung können zusätzlich noch weitere Sensoren, insbesondere neigungs-, winkel-, translations-, beschleunigungs- sowie drehratensensitive Sensoren, vorhanden sein. Nach Aufsetzen des Handmessgeräts 10 auf der Oberfläche 44 eines zu vermessenden Werkstücks 42, beispielsweise auf einer Wand oder auf einem Beton-Boden, wird die Positionsänderung des Handmessgeräts in Folge eines Verfahrens des Geräts auf dem Werkstück ermittelt. Diese Positionsdaten werden zur weiteren Auswertung an eine Auswertevorrichtung 30 weitergegeben. Besonders vorteilhaft lassen sich mittels positionsabhängiger Vermessung und Auswertung eines Werkstücks mehrdimensionale Darstellungen der Messergebnisse, beispielsweise insbesondere in Form einer Karte und/oder einer pseudo-dreidimensionalen Darstellung, erzeugen.

Auf einem Trägerelement 26, insbesondere einer Systemplatine oder Leiterplatte innerhalb des Gehäuses 12, sind weitere Komponenten des Messgeräts 10, insbesondere eine erste Sensorvorrichtung 32 mit einem Kernspinresonanz-Sensor 32', eine zweite Sensorvorrichtung 60 mit einem Ultrabreitband-Radar-Sensor 60', eine Steuervorrichtung 28 zur Ansteuerung der ersten und der zweiten Sensorvorrichtung, eine Auswertevorrichtung 30 zur Auswertung zumindest eines von der ersten und/oder der zweiten Sensorvorrichtung gelieferten Messsignals, sowie eine mit der Steuer- und/oder Auswertevorrichtung verbundenen Datenkommunikationsschnittstelle 54 untergebracht (siehe insbesondere Figur 2).

Die Steuervorrichtung 28 weist eine Steuerelektronik umfassend Mittel zur Kommunikation mit den anderen Komponenten des Messgeräts auf, beispielsweise Mittel zur Steuerung und/oder Regelung der ersten und der zweiten Sensorvorrichtung sowie Mittel zur Steuerung des Messgeräts. Die Steuervorrichtung 28 umfasst insbesondere eine Einheit mit einer Prozessoreinheit, einer Speichereinheit und einem in der Speichereinheit gespeicherten Betriebsprogramm. Die Steuervorrichtung 28 ist dazu vorgesehen, zumindest einen Betriebsfunktionsparameter des Messgeräts in Abhängigkeit von zumindest einer Eingabe durch den Benutzer, durch die Auswertevorrichtung und/oder durch die Datenkommunikationsschnittstelle 54 einzustellen.

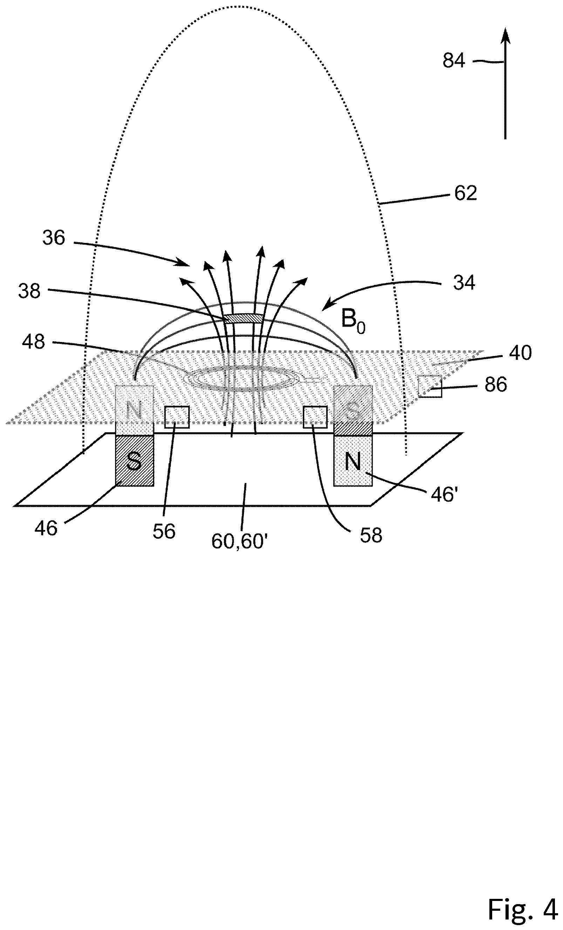

Der Kernspinresonanz-Sensor 32', der detaillierter in Figur 4 erläutert wird, ist zur Anregung einer Kernspinresonanz von Kernspins von Atomkernen des Materials des Werkstücks 42 vorgesehen. Erfindungsgemäß wird das gemessene Resonanzsignal zumindest zur zerstörungsfreien Bestimmung eines Feuchtemesswertes des Werkstücks, insbesondere entsprechend der Messtiefe des Sensors zur Bestimmung eines Feuchtemesswertes in dem Werkstück 42, verwendet, d.h. zur Ermittlung von Informationen, die unter anderem einen relativen und/oder absoluten Feuchtegehalt, einen Feuchtegradienten in das Werkstück hinein, Bindungszustände des die Feuchtigkeit bildenden Wassers und/oder zeitlich dynamische Prozesse des die Feuchtigkeit bildenden Wassers betreffen. Die Messtiefe beträgt dabei insbesondere bis zu 1 cm, vorteilhaft bis zu 2 cm, besonders vorteilhaft bis zu 3 cm in das Werkstück hinein. Das Kernspinresonanz-Signal der in dem Material des Werkstücks 42 angeregten Kernspins der Atomkerne wird mittels einer Empfangsspule des Kernspinresonanz-Sensors 32' detektiert. Das erzeugte Messsignal, insbesondere dessen Amplitude und/oder Relaxationszeiten, wird an die Auswertevorrichtung 30 weitergeleitet, von der es mittels Auswerteroutinen ausgewertet und aufbereitet wird und an eine Ausgabevorrichtung 16 und/oder die Steuervorrichtung 28 und/oder eine Datenkommunikationsschnittstelle 54 weitergeleitet wird.

Der Ultrabreitband-Radar-Sensor 60' wird vorteilhaft genutzt, ein tief in das Material des Werkstücks 42 eindringendes elektromagnetisches Signal auszustrahlen, dessen werkstückinternen Reflektionen und/oder Streuung durch den Sensor gemessen werden. Ein von diesem Sensor erzeugtes Messsignal wird von der Auswertevorrichtung 30 ausgewertet, sodass ein Feuchtemesswert, insbesondere tiefenaufgelöste Feuchtemesswerte, erhalten werden. Insbesondere beträgt die Messtiefe des Ultrabreitband-Radar-Sensor 60' bis zu 10 cm, vorteilhaft bis zu 15 cm und besonders vorteilhaft mehr als 15 cm.

Die Auswertevorrichtung 30 zur Auswertung zumindest eines von der ersten und/oder der zweiten Sensorvorrichtung gelieferten Messsignals, gegebenenfalls auch zur Auswertung von Messsignalen weiterer Sensorvorrichtungen des Handmessgeräts 10, weist insbesondere einen Informationseingang, eine Informationsverarbeitung und einen Informationsausgang auf. Vorteilhaft besteht die Auswertevorrichtung 30 zumindest aus einem Prozessor, einem Speicher mit einem darauf gespeicherten und ausführbaren Betriebsprogramm und erlaubt, zumindest ein Messsignal des Kernspinresonanz-Sensors 32' und/oder ein Messsignal des Ultrabreitband-Radar-Sensors 60' auszuwerten und Feuchtemesswerte bezogen auf das Werkstück zu bestimmen. Besonders vorteilhaft weist die Auswertevorrichtung gespeicherte Korrektur- und/oder Kalibriertabellen auf, die es erlauben, die Auswerteergebnisse zu interpretieren, umzurechnen, zu inter- und/oder extrapolieren sowie das Messgerät, insbesondere die Auswerteroutinen, hinsichtlich eines Werkstückmaterials zu kalibrieren.

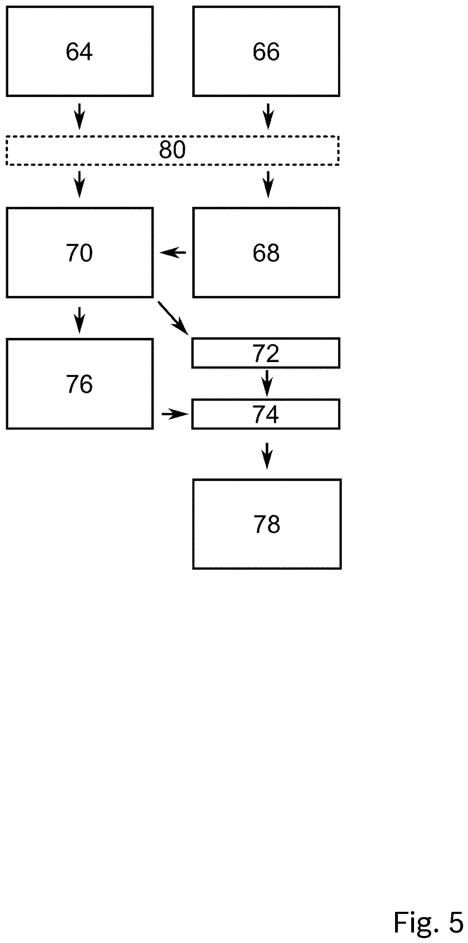

Erfindungsgemäß kann eine mittels des Kernspinresonanz-Sensors 32' erhaltene, die Feuchte des Werkstücks betreffende Information genutzt werden, um die Auswertung eines von dem Ultrabreitband-Radar-Sensors 60' gelieferten Messsignals zu beeinflussen, bevorzugt zu optimieren, besonders bevorzugt zu kalibrieren. Dadurch kann eine an die Gegebenheiten des Werkstücks angepasste und damit optimierte Auswertung von von der zweiten Sensorvorrichtung gelieferten Messsignalen ermöglicht werden. Besonders vorteilhaft können somit relative Feuchtemesswerte des Ultrabreitband-Radar-Sensors 60' in direkten Bezug zu absoluten Feuchtemesswerten, die mittels des Kernspinresonanz-Sensors gemessen werden, gesetzt werden, und somit absolute Feuchtemesswerte bis zu einer maximalen Messtiefe erhalten werden, die der maximalen Messtiefe des Ultrabreitband-Radar-Sensors 60' entspricht (vgl. Figur 5).

Des Weiteren kann eine mittels des Kernspinresonanz-Sensors 32' erhaltene, die Feuchte des Werkstücks betreffende Information, genutzt werden, um über die Steuervorrichtung eine optimierte Ansteuerung der zweiten Sensorvorrichtung, insbesondere des Ultrabreitband-Radar-Sensors 60', zu realisieren. Beispielsweise lassen sich physikalische und/oder technische Steuerparameter und Kenngrößen wie Spannungen, Stromstärken, Pulsdauern, Leistungen, Ausstrahlungsrichtungen des Ultrabreitband-Radar-Sensors 60' in Abhängigkeit der Information regeln und/oder steuern.

Die Auswerteergebnisse werden von der Auswertevorrichtung 30 zur weiteren Verwendung über die Steuervorrichtung 28 entweder zur Versendung der Daten an die Datenkommunikationsschnittstelle 54 oder direkt an einen Nutzer des Messgeräts 10 ausgegeben. Eine Ausgabe an einen Nutzer kann insbesondere mittels Darstellung auf dem Display 16 geschehen. Die Ausgabe auf dem Display 16 kann grafisch, numerisch und/oder alphanumerisch, beispielsweise in Form eines Messwerts, einer Messkurve, eines Signalverlaufs, eines Zeitverlauf, als Bilddaten oder in einer Gradientendarstellung sowie in einer Kombination derer erfolgen. Alternativ oder zusätzlich ist eine Darstellung mittels einer Signalanzeige möglich, insbesondere beispielsweise einer Leuchtdiode, die beispielsweise über eine Farbcodierung (z.B. rot, gelb, grün) eine Zielgröße bewertet.

Zur Bestimmung eines Feuchtemesswerts eines Werkstücks, insbesondere in einem Werkstück, wird das Messgerät 10 mit seiner ersten Gehäuseseite 40, d.h. der Geräterückseite, flächig in unmittelbarer Nähe zu dem Werkstück 42, insbesondere in Berührung zu dessen Oberfläche 44, positioniert. Dabei dringen die durch den Kernspinresonanz-Sensor 32' erzeugten Magnetfelder 34,36 sowie die elektromagnetische Strahlung des Ultrabreitband-Radar-Sensors 60' durch die erste Gehäuseseite 40 aus dem Messgerät 10 aus und in das Werkstück 42 ein, wobei der erste sensitive Bereich 38 und der zweite sensitive Bereich 62 in dem Werkstück zu liegen kommen (siehe insbesondere Figur 3). Das Positionieren des Messgerätes 10 in unmittelbarer Nähe der Werkstückoberfläche 44 ermöglicht die Bestimmung von absoluten Feuchtemesswerten insbesondere bis zu 10 cm, vorteilhaft bis zu 15 cm und besonders vorteilhaft mehr als 15 cm in das Werkstück 42 hinein.

In Figur 3 ist die erfindungsgemäße Ausführungsform des Handmessgeräts 10 der Figuren 1 und 2 in einer vereinfachten schematischen Seitenansicht dargestellt. Der Kernspinresonanz-Sensor 32' umfasst zwei Vorrichtungen zur Erzeugung von Magnetfeldern, insbesondere eine Permanentmagnetanordnung 46,46' (vgl. Figur 4), die ein erstes Magnetfeld 34 erzeugt, sowie eine Hochfrequenzspule 48 (vgl. Figur 4), die ein zweites Magnetfeld 36 erzeugt. Der Kernspinresonanz-Sensor 32' ist derart konfiguriert, dass das erste Magnetfeld 34 im Wesentlichen parallel zu der ersten Gehäuseseite 40 ausgerichtet ist, während das zweite Magnetfeld 36 im Wesentlichen senkrecht zu den Magnetfeldlinien des ersten Magnetfeldes 34 ausgerichtet ist. Die beiden Magnetfelder überlagern sich in einem ausgedehnten Bereich, in dem sich insbesondere auch der sensitive Bereich 38 des Kernspinresonanz-Sensors 32' als insbesondere schichtförmiger Bereich befindet.

Der Ultrabreitband-Radar-Sensor 60', der zur Abstrahlung von elektromagnetischer Strahlung und zur Detektion von im Inneren des Werkstücks reflektierten und/oder gestreuten Signalen vorgesehen ist, weist einen zweiten sensitiven Bereich 62 auf, der identisch ist mit dem Raumwinkel der maximalen Empfindlichkeit des Sensors (Erstreckungsrichtung). Der zweite sensitive Bereich 62 erstreckt sich symmetrisch bezüglich einer Senkrechten zu der ersten Gehäuseseite des Messgeräts, entlang der auch der erste sensitive Bereich 38 des Kernspinresonanz-Sensors 32' vorteilhaft verschoben werden kann.

Das Handmessgerät 10 wird mit der ersten Gehäuseseite 40 in unmittelbarer Nähe an ein zu untersuchendes Werkstück 42 so positioniert, dass der Abstand zwischen der ersten Gehäuseseite 40 und der Werkstückoberfläche 44 minimiert ist. Auf diese Weise wird erreicht, dass die Magnetfelder 34,36 des Kernspinresonanz-Sensors 32' sowie die elektromagnetische Strahlung des Ultrabreitband-Radar-Sensors 60' in das Werkstück eindringen und der erste sowie der zweite sensitive Bereich 38 bzw. 62 im Werkstück 42 zu liegen kommen.

Durch Variation des durch die zweite Vorrichtung erzeugten zweiten Magnetfeldes 36, d.h., insbesondere durch Variation der Hochfrequenzspule 48 und/oder Variation der Frequenz und/oder Variation des Stroms und/oder Variation der Spannung in der Hochfrequenzspule 48, ist es möglich, den ersten sensitiven Bereich 38 in seinem Abstand zu der ersten Gehäuseseite 40 zu verändern und somit den Abstand des sensitiven Bereichs 38 im Werkstück zu dessen Werkstückoberfläche 44 zu modifizieren. Alternativ und/oder zusätzlich kann der Kernspinresonanz-Sensor 32' im Gehäuse 12 des Handmessgeräts 10 derart, insbesondere mechanisch, umpositioniert werden, dass der Abstand des Kernspinresonanz-Sensors 32' zur ersten Gehäuseseite 40 verändert wird und folglich auch der Abstand des ersten sensitiven Bereichs 38 im Werkstück 42 zu dessen Werkstückoberfläche 44. Besonders vorteilhaft lassen sich auf diese Weise Tiefenprofile der Feuchtemesswerte erstellen.

Erfindungsgemäß kann eine mittels des Kernspinresonanz-Sensors erhaltene, die Feuchte des Werkstücks betreffende Information genutzt werden, um die Auswertung eines von dem Ultrabreitband-Radar-Sensor 60' gelieferten Messsignals zu beeinflussen, bevorzugt zu optimieren, besonders bevorzugt zu kalibrieren. Dadurch kann eine an die Gegebenheiten des Werkstücks angepasste und damit optimierte Auswertung von von der zweiten Sensorvorrichtung 60 gelieferten Messsignalen ermöglicht werden. Besonders vorteilhaft können somit relative Feuchtemesswerte des Ultrabreitband-Radar-Sensors 60' in direkten Bezug zu absoluten Feuchtemesswerten, die mittels des Kernspinresonanz-Sensors 32' gemessen werden, gesetzt werden, und somit absolute Feuchtemesswerte bis zu einer maximalen Messtiefe erhalten werden, die der maximalen Messtiefe des Ultrabreitband-Radar-Sensors 60' entspricht (vgl. Figur 5).

In Figur 4 sind in vereinfachter und schematischer Darstellung die Komponenten einer Ausführungsform des erfindungsgemäßen Kernspinresonanz-Sensors 32' sowie des Ultrabreitband-Radar-Sensors 60' dargestellt. Zwei senkrecht zur ersten Gehäuseseite 40 und antiparallel zueinander angeordnete Permanentmagnete 46, 46' erzeugen ein erstes, insbesondere statisches, Magnetfeld 34, das im Wesentlichen parallel zur Oberfläche der ersten Gehäuseseite 40 verläuft. Dieses zur Ausrichtung der Kernspins der in der Materialprobe vorhandenen Atomkerne vorgesehene erste Magnetfeld weist beispielhaft insbesondere eine Magnetfeldstärke von 0.5 Tesla auf, wobei die Permanentmagnete aus einer Neodym-Eisen-Bor-Legierung hergestellt sind. Die zweite Vorrichtung zur Erzeugung des zweiten Magnetfeldes wird in diesem Ausführungsbeispiel durch eine Hochfrequenzspule 48 gebildet. Sobald durch diese Spule Strom fließt, wird ein elektromagnetisches Feld, insbesondere das zweite Magnetfeld 36, erzeugt. Die beiden Magnetfelder überlagern sich in einem Bereich, der im Wesentlichen außerhalb des Gehäuses 12 des Messgeräts 10 liegt. Der sensitive Bereich 38 des Kernspinresonanz-Sensors 32' liegt ebenfalls in dem Überlagerungsfeld der Magnetfelder 34 und 36. In Abhängigkeit der Frequenz des eingestrahlten elektromagnetischen Felds 36 und der statischen Magnetfeldstärke des ersten Magnetfelds 34 wird der sensitive Bereich im Idealfall durch eine Fläche definiert, auf der die Magnetfeldstärke des ersten Magnetfelds 34 konstant ist und insbesondere einen definierten Betrag aufweist. In Realität ist die Fläche auf Grund nicht exakter Frequenzen tatsächlich schichtförmig. Da die Magnetfeldlinien 34 nicht exakt parallel zur ersten Gehäuseseite 40 verlaufen, ist somit auch der sensitive Bereich 38 folglich entsprechend der Magnetfeldlinien gekrümmt. Die Krümmung und Ausformung des ersten Magnetfelds 34 und damit des sensitiven Bereichs 38 kann unter Verwendung weiterer Mittel, beispielsweise einer Shim-Spule 56 und/oder einer magnetischen Schirmung 58, beeinflusst und insbesondere homogenisiert werden.

Der Ultrabreitband-Radar-Sensor 60' ist als elektrisch leitende Fläche dargestellt, insbesondere als ein Metallblech dargestellt. Der zweite sensitive Bereich 62 des Ultrabreitband-Radar-Sensor 60' entspricht der Hauptausstrahlungsrichtung des Sensors und spannt daher einen Abstrahlungskegel auf, der bei geeigneter Positionierung des Messgeräts tief in das Werkstück eindringen kann.

Figur 5 stellt einen möglichen Messablauf mit dem erfindungsgemäßen Messgerät schematisch dar. Beginnend mit der Messung des Kernspinresonanz-Sensors 32' in Schritt 64 werden für verschiedene Messtiefen $z_m$ ($m=1...a$) in das Werkstück hinein bis zur maximalen Messtiefe $z_a$ des Kernspinresonanz-Sensors Volumenanteile $V_m$ des die Feuchte bildenden Wassers als Funktion $F_1$ der Messtiefe $z_m$ der diskreten Schichten $m=1...a$ in dem Werkstück ermittelt:

$$V_{1...a} = F_1 (z_{1...a}) \hspace{3cm} (1)$$

Die zweite Sensorvorrichtung 60, hier am Beispiel eines Radar-Sensors 60', erlaubt, Messsignale $S|_{1...b}$ in dem Werkstück bis zur maximalen Messtiefe $z_b = \sum_{m=1}^{b} d_m$ des Radar-Sensors zu messen, dargestellt in Schritt 66. Im Sonderfall, dass $d_m$ konstant ist für verschiedene $m$, lässt sich die maximale Messtiefe zu $z_b = b \cdot d_m$ vereinfachen. Das Messsignal $S|_{1...b}$ hängt im Wesentlichen ab (funktioneller Zusammenhang $F_2$) von der Radar-Frequenz f, den Schicht-

dicken $d_m$ und deren komplexwertigen effektiven Baustoff-Permittivitäten $\varepsilon_{eff,m}$ ($V_m$, $d_m$, $\varepsilon_{eff,m}$ etc. stellen Parameter jeweils einer einzelnen Schicht dar):

$$S|_{1...b} = F_2 (f, d_{1...b}, \varepsilon_{eff,1...b}) = F_3 (f, d_{1...b}, \varepsilon_T, \varepsilon_{Wasser}, V_{1...b}) = F_4 (d_{1...b}) \qquad (2)$$

Alternativ lässt sich das Messsignal auch als Funktion ($F_3$) der Radar-Frequenz f, der Schichtdicken $d_m$, der Trockenpermittivität $\varepsilon_T$ des Materials des Werkstücks, der Permittivität $\varepsilon_{Wasser}$ und des Volumenanteils $V_m$ des die Feuchte bildenden Wassers in der entsprechenden Messtiefe ausdrücken.

Das Signal $S|_{1...b}$ lässt sich aufspalten in Signalanteile $S|_{1...a}$ und $S|_{a+1...b}$, wobei letzterer Signalanteil von Schichten stammt, die über die maximale Messtiefe $z_a$ des Kernspinresonanz-Sensors 32' hinausgehen (Schritt 68):

$$S|_{1...b} = F (S|_{1...a} + S|_{a+1...b}) \qquad (3)$$

Durch Nullsetzen der über die Messtiefe des Kernspinresonanz-Sensors 32' hinausgehenden Signalanteile $S|_{a+1...b}$ oder direktes Bestimmen der oberflächennahen Reflektion $S|_{1...a}$ (beispielsweise durch Modellierung der Messdaten) können die Messwerte des Kernspinresonanz-Sensors 32' und die des Radar-Sensors 60' für die Messtiefe bis $z_a$ korreliert werden und die Trockenpermittivität $\varepsilon_T$ in Schritt 70 bestimmt werden:

$$\varepsilon_{eff,1...a}^{\alpha} = \left(1 - V_{1...a} - \sum_{i=1}^{n} V_i'\right) \cdot \varepsilon_T^{\alpha} + V_{1...a} \cdot \varepsilon_{1...a}^{\alpha} + \sum_{i=1}^{n} V_i' \varepsilon_i^{\alpha} \qquad (4)$$

Darin stellen $V_i'$ und $\varepsilon_i$ Volumenanteile bzw. Permittivitäten weiterer Stoffanteile im Material des Werkstücks dar, beispielsweise von Kapillarwasser, Lufteinschlüssen etc. Der Parameter $\alpha$ ist durch ein zu Grunde liegendes Modell bestimmt.

Mit Kenntnis der Trockenpermittivität $\varepsilon_T$ kann der Signalanteil $S|_{a+1...b}$ der tieferliegenden Schichten hinsichtlich Volumenanteil des Wassers der Feuchtigkeit ausgewertet werden (Schritt 72).

Bei Kenntnis der Materialdichte p lassen sich in Schritt 74 die Volumenanteile des Wassers der Feuchtigkeit in Masseanteile umrechnen. Die Materialdichte kann entweder durch Spezifikation des Materials des Werkstücks durch den Nutzer oder alternativ ebenfalls aus einer Messung mit dem Kernspinresonanz-Sensor 32' in Schritt 76 erfolgen. Schließlich werden die ermittelten Messwerte an den Nutzer ausgeben (Schritt 78), beispielsweise mittels eines Displays 16, einer LED, einer Farbskala oder über ein drahtlos mit dem Messgerät verbundenes Datengerät, insbesondere ein Smartphone.

Bei Spezifikation des Materials durch den Nutzer lassen sich ferner Korrekturen und/oder Kalibrierungen der Messsignale des Kernspinresonanz-Sensors 32' und/oder des Radar-Sensors 60' in Schritt 80 durchführen. Beispielsweise können Beiträge organischer Bestandteile des Werkstücks zu den Messsignalen des die Feuchtigkeit bildenden Wassers über Kalibriertabellen berücksichtigt werden.

Alternativ kann eine geräteinterne Kalibrierfunktion bereitgestellt werden, mittels der sich relevante Parameter, insbesondere beispielsweise die Trockenpermittivität, bei Vorliegen eines trockenen Werkstücks messen und zur weiteren Verwendung im Gerät abspeichern lassen, sodass eine Kalibrierung der Messsignale des Kernspinresonanz-Sensors 32' in Schritt 80 vorgenommen werden kann.

Ferner können durch Eingabe von Materialparametern, insbesondere einer Schichtabfolge des das Werkstück aufbauenden Materials, Kalibrierdaten zur Kalibrierung der Messsignale bzw. deren Auswertung in Schritt 80 erhalten werden. Alternativ oder zusätzlich können diese Kalibrierdaten auch aus Messsignalen des Kernspinresonanz-Sensors 32' oder des Radar-Sensors 60' in Schritt 80 abgeleitet werden.

**Patentansprüche**

1. Mobiles Messgerät, insbesondere Handmessgerät, zur zerstörungsfreien Bestimmung einer in einem Werkstück vorhandenen Feuchte, aufweisend ein Gehäuse (12), in dem zumindest

   • eine erste Sensorvorrichtung (32), eine zweite Sensorvorrichtung (60),

- eine Steuervorrichtung (28) zur Ansteuerung der ersten und/oder der zweiten Sensorvorrichtung,
- eine Auswertevorrichtung (30) zur Auswertung zumindest eines von der ersten und/oder der zweiten Sensorvorrichtung gelieferten Messsignals, sowie
- eine Vorrichtung zur Energieversorgung (22) des Messgeräts vorgesehen sind, wobei die erste Sensorvorrichtung zumindest einen Kernspinresonanz-Sensor (32') (NMR-Sensor) aufweist, wobei der Kernspinresonanz-Sensor (32') eine Vorrichtung zur Detektion einer Magnetfeldänderung, insbesondere eine Empfangsspule zur Detektion einer Magnetfeldänderung, eine erste Vorrichtung (46,46') zur Erzeugung eines ersten Magnetfelds (34) zur Ausrichtung von Kernspins und eine zweite Vorrichtung (48), insbesondere eine Hochfrequenzspule, zur Erzeugung eines zweiten Magnetfelds (36) zur Anregung der Kernspins aufweist, welches das erste Magnetfeld (34) überlagert, wobei die Steuervorrichtung (28) zumindest eine Steuereinheit zur Steuerung der zweiten Vorrichtung (48) aufweist, wobei die Steuereinheit zur Modifikation des zweiten Magnetfelds (36), insbesondere zur Erzeugung von Pulssequenzen, vorgesehen ist, und

die zweite Sensorvorrichtung zumindest einen Sensor (60') aus einer Gruppe von Kapazitäts-, Mikrowellen-, Ultraschall-, Widerstands-, Leitfähigkeits- und Radar-Sensoren, insbesondere Ultrabreitband-Radar- und Breitband-Impuls-Radar-Sensoren, aufweist,
wobei die Auswertevorrichtung dazu eingerichtet ist, durch Auswertung eines von der ersten Sensorvorrichtung (32) gelieferten Messsignals eine Information über die im Werkstück vorhandene Feuchte zu gewinnen, wobei die Steuervorrichtung unter Verwendung der Information zur optimierten Ansteuerung der zweiten Sensorvorrichtung (60) und/oder die Auswertevorrichtung unter Verwendung der Information zur optimierten Auswertung von von der zweiten Sensorvorrichtung (60) gelieferten Messsignalen eingerichtet ist.

2. Messgerät nach Anspruch 1, **dadurch gekennzeichnet, dass** die Magnetfelder (34,36) des Kernspinresonanz-Sensors (32') einen ersten sensitiven Bereich (38) des Kernspinresonanz-Sensors (32') definieren, insbesondere einen schichtförmigen Bereich, der sich im Wesentlichen parallel und beabstandet zu einer ersten Gehäuseseite (40) außerhalb des Gehäuses (12) des Messgeräts (10) erstreckt.

3. Messgerät nach Anspruch 2, **dadurch gekennzeichnet, dass** sich der erste sensitive Bereich (38) des Kernspinresonanz-Sensors (32'),durch Modifikation der Magnetfelder oder durch mechanisches Verfahren des Kernspinresonanz-Sensors (32') im Gehäuse (12), entlang einer Senkrechten (84) zu der ersten Gehäuseseite (40) des Messgeräts außerhalb des Gehäuses (12) verschieben lässt, vorteilhaft um 1 cm, besonders vorteilhaft um 2 cm, insbesondere um 3 cm verschieben lässt.

4. Messgerät nach einem der Ansprüche 2 oder 3, **dadurch gekennzeichnet, dass** die zweite Sensorvorrichtung (60) einen zweiten sensitiven Bereich (62) aufweist, der sich im Wesentlichen symmetrisch bezüglich einer Senkrechten (84) zu der ersten Gehäuseseite (40) des Messgeräts (10) entlang dieser Senkrechten erstreckt.

5. Messgerät nach einem der Ansprüche 2-4, **dadurch gekennzeichnet, dass** Mittel vorgesehen sind, die erlauben, die Erstreckungsrichtung und/oder die Homogenität und/oder die Geometrie des ersten (38) und/oder des zweiten sensitiven Bereichs (62) zu beeinflussen.

6. Messgerät nach einem der vorhergehenden Ansprüche, **dadurch gekennzeichnet, dass** Schirmungsmittel (58) vorgesehen sind, die es erlauben, Störeinflüsse der Sensorvorrichtungen (32,60) untereinander zu minimieren.

7. Messgerät nach einem der vorhergehenden Ansprüche, **dadurch gekennzeichnet, dass** die Auswertevorrichtung (30) zur Auswertung zumindest eines von der ersten (32) und/oder der zweiten Sensorvorrichtung (60) gelieferten Messsignals ausgebildet ist, insbesondere

- einen relativen und/oder absoluten Feuchtegehalt und/oder
- einen Feuchtegradienten in das Werkstück (42) hinein und/oder
- Bindungszustände des die Feuchtigkeit bildenden Wassers und/oder
- zeitlich-dynamische Prozesse des die Feuchtigkeit bildenden Wassers und/oder

des Materials des Werkstücks (42) auszuwerten.

8. Messgerät nach einem der Ansprüche 3 oder 4, **dadurch gekennzeichnet, dass** eine Eingabevorrichtung (14) zur Eingabe von Arbeitsparametern vorhanden ist, insbesondere eine Eingabevorrichtung, die in oder an einer zweiten Gehäuseseite (20) des Messgeräts angeordnet ist.

9. Messgerät nach einem der Ansprüche 3 oder 4, **dadurch gekennzeichnet, dass** eine Ausgabevorrichtung (16) zur Ausgabe von Arbeitsparametern und/oder Auswerteergebnissen vorhanden ist, insbesondere eine Ausgabevorrichtung, die in einer zweiten Gehäuseseite (20) des Messgeräts angeordnet ist.

10. Messgerät nach einem der Ansprüche 3 oder 4 oder 8 oder 9, **dadurch gekennzeichnet, dass** die erste Gehäuseseite (40) des Messgeräts der die Eingabevorrichtung (14) und/oder die Ausgabevorrichtung (16) aufnehmenden zweiten Gehäuseseite (20) gegenüberliegt, insbesondere geräterückseitig angeordnet ist.

11. Messgerät nach einem der vorhergehenden Ansprüche, **dadurch gekennzeichnet, dass** die Steuervorrichtung (28) einen Bedienmodus aufweist, in welchem Angaben zu einem Werkstück (42) durch Benutzereingaben spezifiziert und/oder dem Messgerät (10) zur Verfügung gestellt werden können.

12. Messgerät nach Anspruch 9, **dadurch gekennzeichnet, dass** die Steuervorrichtung (28) einen Bedienmodus aufweist, in welchem Ausgabeparameter der Ausgabevorrichtung (16) spezifiziert und/oder dem Messgerät (10) zur Verfügung gestellt werden können.

13. Verfahren zur zerstörungsfreien Bestimmung einer in einem Werkstück (42) vorhandene Feuchte mittels eines mobilen Messgeräts (10) nach einem der vorhergehenden Ansprüche, bei welchem mittels zumindest der ersten Sensorvorrichtung (32) mindestens eine erste Information über die im Werkstück (42) vorhandene Feuchte gewonnen wird, und die zweite Sensorvorrichtung (60) zur Gewinnung zumindest einer zweiten Z Information über die im Werkstück (42) vorhandene Feuchte genutzt wird, wobei die erste Information zur optimierten Ansteuerung der zweiten Sensorvorrichtung (60) und/oder zur optimierten Auswertung von von der zweiten Sensorvorrichtung (60) gelieferten Messsignalen genutzt wird.

14. Verfahren nach Anspruch 13, **dadurch gekennzeichnet, dass** die von der ersten Sensorvorrichtung (32) gewonnene erste Information zur Kalibrierung der zweiten Sensorvorrichtung (60) und/oder zur Kalibrierung der von der zweiten Sensorvorrichtung (60) gelieferten Messsignale genutzt wird.

15. Verfahren nach Anspruch 13 oder 14, **dadurch gekennzeichnet, dass** zumindest eine mittels der ersten Sensorvorrichtung (32) über die im Werkstück (42) vorhandene Feuchte gewonnene Information genutzt wird, die Trocken-permittivität $\varepsilon_T$ des Werkstücks zu bestimmen.

16. Verfahren nach einem der Ansprüche 13-15, **dadurch gekennzeichnet, dass** das mit der ersten und der zweiten Sensorvorrichtung (32,60) parallel und/oder quasi-parallel und/oder seriell gemessen wird.

## Claims

1. Mobile measuring appliance, in particular a hand-held measuring appliance, for non-destructive determination of a moisture present in a workpiece, said mobile measuring appliance comprising a housing (12), provided in which there is at least

   • a first sensor apparatus (32), a second sensor apparatus (60),
   • a control apparatus (28) for actuating the first sensor apparatus and/or the second sensor apparatus,
   • an evaluation apparatus (30) for evaluating at least one measurement signal supplied by the first sensor apparatus and/or the second sensor apparatus, and
   • an apparatus for supplying energy (22) to the measuring appliance,
   wherein the first sensor apparatus comprises at least one nuclear magnetic resonance sensor (32') (NMR sensor), wherein the nuclear magnetic resonance sensor (32') comprises an apparatus for detecting a magnetic field change, in particular a reception coil for detecting a magnetic field change, a first apparatus (46, 46') for generating a first magnetic field (34) for aligning nuclear spins and a second apparatus (48), in particular a radiofrequency coil, for generating a second magnetic field (36) for exciting the nuclear spins, said second magnetic field superimposing the first magnetic field (34), wherein the control apparatus (28) comprises at least one control unit for controlling the second apparatus (48), wherein the control unit is provided for modifying the second magnetic field (36), in particular for generating pulse sequences, and
   the second sensor apparatus comprises at least one sensor (60') from a group of capacitance sensors, microwave sensors, ultrasonic sensors, resistance sensors, conductivity sensors and radar sensors, in particular ultra-broadband radar sensors and broadband impulse radar sensors,

wherein the evaluation apparatus is configured to obtain an information item about the moisture present in the workpiece by evaluating a measurement signal supplied by the first sensor apparatus (32), wherein the control apparatus is configured, using the information item, for the optimized actuation of the second sensor apparatus (60) and/or the evaluation apparatus is configured, using the information item, for the optimized evaluation of measurement signals supplied by the second sensor apparatus (60).

2. Measuring appliance according to Claim 1, **characterized in that** the magnetic fields (34, 36) of the nuclear magnetic resonance sensor (32') define a first sensitive region (38) of the nuclear magnetic resonance sensor (32'), in particular a layer-shaped region which extends substantially parallel to and at a distance from a first housing side (40) outside of the housing (12) of the measuring appliance (10).

3. Measuring appliance according to Claim 2, **characterized in that** the first sensitive region (38) of the nuclear magnetic resonance sensor (32') may be displaced, advantageously by 1 cm, particularly advantageously by 2 cm, in particular by 3 cm, outside of the housing (12) along a perpendicular (84) to the first housing side (40) of the measuring appliance by modifying the magnetic fields or by way of a mechanical displacement of the nuclear magnetic resonance sensor (32') in the housing (12).

4. Measuring appliance according to either of Claims 2 and 3, **characterized in that** the second sensor apparatus (60) has a second sensitive region (62) which extends substantially symmetrically in relation to a perpendicular (84) to the first housing side (40) of the measuring appliance (10) along said perpendicular.

5. Measuring appliance according to any one of Claims 2-4, **characterized in that** provision is made of means which allow the direction of extent and/or the homogeneity and/or the geometry of the first sensitive region (38) and/or of the second sensitive region (62) to be influenced.

6. Measuring appliance according to any one of the preceding claims, **characterized in that** provision is made of shielding means (58) which allow mutual interference influences among the sensor apparatuses (32, 60) to be minimized.

7. Measuring appliance according to any one of the preceding claims, **characterized in that** the evaluation apparatus (30) is embodied to evaluate at least one measurement signal supplied by the first sensor apparatus (32) and/or the second sensor apparatus (60), in particular to evaluate

- a relative and/or absolute moisture content and/or
- a moisture gradient into the workpiece (42) and/or
- binding states of the water forming the moisture and/or
- time-dynamic processes of the water forming the moisture and/or

of the material of the workpiece (42).

8. Measuring appliance according to either of Claims 3 and 4, **characterized in that** an input apparatus (14) for inputting working parameters is present, in particular an input apparatus which is arranged in or on a second housing side (20) of the measuring appliance.

9. Measuring appliance according to either of Claims 3 and 4, **characterized in that** an output apparatus (16) for outputting working parameters and/or evaluation results is present, in particular an output apparatus which is arranged in a second housing side (20) of the measuring appliance.

10. Measuring appliance according to any one of Claims 3 and 4 and 8 and 9, **characterized in that** the first housing side (40) of the measuring appliance lies opposite the second housing side (20) receiving the input apparatus (14) and/or the output apparatus (16), in particular is arranged on the appliance rear side.

11. Measuring appliance according to any one of the preceding claims, **characterized in that** the control apparatus (28) has an operating mode in which specifications relating to a workpiece (42) may be specified by user inputs and/or may be made available to the measuring appliance (10).

12. Measuring appliance according to Claim 9, **characterized in that** the control apparatus (28) has an operating mode in which output parameters of the output apparatus (16) may be specified and/or may be made available to the measuring appliance (10).

13. Method for non-destructive determination of a moisture present in a workpiece (42) by means of a mobile measuring appliance (10) according to any one of the preceding claims, in which at least one first information item about the moisture present in the workpiece (42) is obtained by means of at least the first sensor apparatus (32) and the second sensor apparatus (60) is used to obtain at least one second information item about the moisture present in the workpiece (42), wherein the first information item is used for optimized actuation of the second sensor apparatus (60) and/or for optimized evaluation of measurement signals supplied by the second sensor apparatus (60).

14. Method according to Claim 13, **characterized in that** the first information item obtained by the first sensor apparatus (32) is used to calibrate the second sensor apparatus (60) and/or to calibrate the measurement signals supplied by the second sensor apparatus (60).

15. Method according to Claim 13 or 14, **characterized in that** at least one information item about the moisture present in the workpiece (42) obtained by means of the first sensor apparatus (32) is used to determine the dry permittivity $\varepsilon_T$ of the workpiece.

16. Method according to any one of Claims 13-15, **characterized in that** a parallel and/or quasiparallel and/or series measurement is carried out with the first sensor apparatus (32) and the second sensor apparatus (60).

**Revendications**

1. Appareil de mesure mobile, en particulier appareil de mesure à main, destiné à déterminer de manière non destructive l'humidité présente dans une pièce, ledit appareil comportant un boîtier (12) dans lequel sont prévus au moins

   • un premier dispositif capteur (32), un deuxième dispositif capteur (60),
   • un dispositif de commande (28) destiné à commander le premier et/ou le deuxième dispositif capteur,
   • un dispositif d'évaluation (30) destiné à évaluer au moins un signal de mesure fourni par le premier et/ou le deuxième dispositif capteur,
   ainsi que
   • un dispositif d'alimentation en énergie (22) de l'appareil de mesure,
   le premier dispositif capteur comportant au moins un capteur de résonance magnétique nucléaire (32') (capteur NMR), le capteur de résonance magnétique nucléaire (32') comportant un dispositif de détection d'une variation de champ magnétique, en particulier une bobine réceptrice destinée à détecter une variation de champ magnétique, un premier dispositif (46, 46') destiné à générer un premier champ magnétique (34) afin d'orienter des spins nucléaires et un deuxième dispositif (48), en particulier une bobine à haute fréquence, destiné à générer un deuxième champ magnétique (36) afin d'exciter les spins nucléaires, lequel est superposé au premier champ magnétique (34), le dispositif de' commande (28) comportant au moins une unité de commande destinée à commander le deuxième dispositif (48), l'unité de commande étant prévue pour modifier le deuxième champ magnétique (36), en particulier pour générer des séquences d'impulsions, et
   le deuxième dispositif capteur comportant au moins un capteur (60') parmi un groupe de capteurs capacitifs, hyperfréquences, ultrasonores, résistifs, conductométriques et radar, notamment radar ultra large bande et radar impulsionnel large bande,
   le dispositif d'évaluation étant conçu pour obtenir une information sur l'humidité présente dans la pièce en évaluant un signal de mesure fourni par le premier dispositif capteur (32),
   le dispositif de commande étant conçu pour commander de manière optimisée, en utilisant l'information, le deuxième dispositif capteur (60) et/ou le dispositif d'évaluation étant conçu pour évaluer de manière optimisée, en utilisant l'information, des signaux de mesure fournis par le deuxième dispositif capteur (60).

2. Appareil de mesure selon la revendication 1, **caractérisé en ce que** les champs magnétiques (34, 36) du capteur à résonance magnétique nucléaire (32') définissent une première zone sensible (38) du capteur à résonance magnétique nucléaire (32'), notamment une zone stratiforme qui s'étend sensiblement parallèlement à un premier côté de boîtier (40) et à distance de celui-ci, à l'extérieur du boîtier (12) de l'appareil de mesure (10).

3. Appareil de mesure selon la revendication 2, **caractérisé en ce que** la première zone sensible (38) du capteur à résonance magnétique nucléaire (32') peut coulisser le long d'une perpendiculaire (84) au premier côté de boîtier (40) de l'appareil de mesure à l'extérieur du boîtier (12), avantageusement de 1 cm, de manière particulièrement avantageuse de 2 cm, en particulier de 3 cm, par modification des champs magnétiques ou par déplacement mécanique du capteur à résonance magnétique nucléaire (32') dans le boîtier (12).

4. Appareil de mesure selon l'une des revendications 2 et 3, **caractérisé en ce que** le deuxième dispositif capteur (60) comporte une deuxième zone sensible (62) qui s'étend le long d'une perpendiculaire (84) au premier côté de boîtier (40) de l'appareil de mesure (10) de manière sensiblement symétrique par rapport à cette perpendiculaire.

5. Appareil de mesure selon l'une des revendications 2 à 4, **caractérisé en ce que** des moyens sont prévus qui permettent d'influer sur la direction d'extension et/ou l'homogénéité et/ou la géométrie de la première (38) et/ou de la deuxième zone sensible (62).

6. Appareil de mesure selon l'une des revendications précédentes, **caractérisé en ce que** des moyens de blindage (58) sont prévus qui permettent de minimiser les interférences entre les dispositifs capteurs (32, 60).

7. Appareil de mesure selon l'une des revendications précédentes, **caractérisé en ce que** le dispositif d'évaluation (30) est conçu pour évaluer au moins un signal de mesure fourni par le premier (32) et/ou le deuxième dispositif capteur (60), notamment pour évaluer

   • une teneur en humidité relative et/ou absolue et/ou
   • un gradient d'humidité dans la pièce (42) et/ou
   • des états de liaison de l'eau formant l'humidité et/ou
   • des processus temporellement dynamiques de l'eau formant l'humidité et/ou du matériau de la pièce (42).

8. Appareil de mesure selon l'une des revendications 3 et 4, **caractérisé en ce qu'**un dispositif d'entrée (14) est prévu pour entrer des paramètres de travail, en particulier un dispositif d'entrée qui est disposé dans ou sur un deuxième côté de boîtier (20) de l'appareil de mesure.

9. Appareil de mesure selon l'une des revendications 3 et 4, **caractérisé en ce qu'**un dispositif de sortie (16) est prévu pour délivrer des paramètres de travail et/ou des résultats d'évaluation, en particulier un dispositif de sortie qui est disposé dans un deuxième côté de boîtier (20) de l'appareil de mesure.

10. Appareil de mesure selon l'une des revendications 3 ou 4 ou 8 ou 9, **caractérisé en ce que** le premier côté de boîtier (40) de l'appareil de mesure est opposé au deuxième côté de boîtier (20) recevant le dispositif d'entrée (14) et/ou le dispositif de sortie (16), notamment du côté arrière de l'appareil.

11. Appareil de mesure selon l'une des revendications précédentes, **caractérisé en ce que** le dispositif de commande (28) possède un mode de fonctionnement dans lequel des données sur une pièce (42) peuvent être spécifiées par des entrées d'utilisateur et/ou mises à la disposition de l'appareil de mesure (10).

12. Appareil de mesure selon la revendication 9, **caractérisé en ce que** le dispositif de commande (28) possède un mode de fonctionnement dans lequel des paramètres de sortie du dispositif de sortie (16) peuvent être spécifiés et/ou mis à disposition de l'appareil de mesure (10).

13. Procédé de détermination non destructive de l'humidité présente dans une pièce (42) au moyen d'un appareil de mesure mobile (10) selon l'une des revendications précédentes, procédé dans lequel au moins une première information sur l'humidité présente dans la pièce (42) est fournie au moins au moyen du premier dispositif capteur (32), et le deuxième dispositif capteur (60) est utilisé pour obtenir au moins une deuxième information sur l'humidité présente dans la pièce (42), la première information étant utilisée pour commander de manière optimisée le deuxième dispositif capteur (60) et/ou pour évaluer de manière optimisée des signaux de mesure fournis par le deuxième dispositif capteur (60).

14. Procédé selon la revendication 13, **caractérisé en ce que** la première information obtenue du premier dispositif capteur (32) est utilisée pour étalonner le deuxième dispositif capteur (60) et/ou pour étalonner les signaux de mesure fournis par le deuxième dispositif capteur (60).

15. Procédé selon la revendication 13 ou 14, **caractérisé en ce qu'**au moins une information obtenue sur l'humidité présente dans la pièce (42) au moyen du premier dispositif capteur (32) est utilisée pour déterminer la permittivité à sec $\varepsilon_T$ de la pièce.

**16.** Procédé selon l'une des revendications 13 à 15, **caractérisé en ce que** les mesures sont effectuées en parallèle et/ou de manière quasi-parallèle et/ou en série avec le premier et le deuxième dispositif capteur (32, 60).

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008055196 A1

- EP 2182390 A2

**In der Beschreibung aufgeführte Nicht-Patentliteratur**

- **PRADO et al.** NMR hand-held moisture sensor. *MRI,* 2001, vol. 19 (3-4), 505-508

- **FERRARA C. et al.** Integrated GPR and unilateral NMR approach to estimate water content in a porous material. *6th International Workshop on Advanced Ground Penetrating Radar,* 2011, 1-4